# EUROPEAN PATENT SPECIFICATION

(11) **EP 4 344 177 B1**
(45) Date of publication and mention of the grant of the patent: **01.07.2026**
(21) Application number: 23769094.6
(22) Date of filing: 07.08.2023
(51) Int. Cl.: H04M 1/02, G06F 1/16

(54) **ELECTRONIC APPARATUS COMPRISING DISPLAY**
ELEKTRONISCHE VORRICHTUNG MIT ANZEIGE
APPAREIL ÉLECTRONIQUE COMPRENANT UN ÉCRAN

(30) Priority: 05.08.2022 KR 20220098079; 12.10.2022 KR 20220130242
(43) Date of publication of application: 27.03.2024
(73) Proprietor: Samsung Electronics Co., Ltd., Suwon-si, Gyeonggi-do 16677 (KR)
(72) Inventor: KANG, Jihoon, Suwon-si, Gyeonggi-do 16677 (KR); KIM, Myungsoo, Suwon-si, Gyeonggi-do 16677 (KR); BAEK, Inyoul, Suwon-si, Gyeonggi-do 16677 (KR); CHOI, Seungwhee, Suwon-si, Gyeonggi-do 16677 (KR)
(74) Representative: Gulde & Partner
(86) International application number: PCT/KR2023/011598
(87) International publication number: WO 2024/030006

(56) References cited:
- KR-A- 20210 047 753
- KR-A- 20210 152 910
- KR-A- 20220 001 241
- KR-A- 20220 055 218
- US-A1- 2019 200 466
- US-A1- 2022 132 682

## Description

### [Technical Field]

The disclosure relates to an electronic device including a display.

### [Background Art]

An electronic device may include a bezel (or an outer frame (e.g., a frame surrounding a screen when viewing the screen of the electronic device)) disposed along the periphery of the display.

The foregoing information may be provided as a related art for the purpose of helping understanding of the disclosure. No claim or determination is made as to whether any of the foregoing may be applied as a prior art related to the disclosure.

Conventional devices are known from US 2022/132682 A1.

### [Disclosure of Invention]

### [Technical Problem]

When an external impact is applied to the bezel of the electronic device due to a reason such as a drop, the display may be damaged due to a collision between the bezel and the display. When the bezel or the gap between the bezel and the display is reduced to make the screen feel larger, the possibility of damage to the display due to an external impact may be higher.

Exemplary embodiments of the disclosure may provide an electronic device including a display capable of reducing damage to the display from an external impact.

The technical problems to be addressed by the disclosure are not limited to those described above, and other technical problems, which are not described above, will be understood by a person ordinarily skilled in the related art, to which this disclosure belongs.

### [Solution to Problem]

According to an exemplary embodiment of the disclosure, an electronic device may include a housing, a display module, a support piece, and/or a frame. The housing may include a support and a side surface area connected to or extending from the support and providing at least a portion of the side surface of the electronic device. The display module may be disposed on the housing. The display module may include a display and an extension. The support of the housing may support the rear surface of the display. The extension may include a bent area that is bent and extends from the display to a partial area disposed between the support of the housing and the display. The support piece may be disposed in a recess provided in the support of the housing. The frame may be coupled with the housing. The frame may include a first portion and a second portion. The first portion may cover a border area of the display and may be exposed to the outside. The second portion may extend from the first portion between the bent area of the extension and the side surface area of the housing. The second portion may be configured to be inserted into a space between the support piece and the side surface area in the recess.

### [Advantageous Effects of Invention]

With the electronic device including the display according to an embodiment of the disclosure, it is possible not only to ensure a gap between the bezel (e.g., a combination of the side surface area of the housing and the first portion of the frame) to suppress the breakage of the display module (e.g., the bent area of the extension) from an external impact, but also to provide a thin bezel so that a user may feel a larger screen size.

In addition, effects that may be obtained or predicted by various embodiments of the disclosure may be directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 is a block diagram of an electronic device according to an embodiment of the disclosure in a network environment.
FIG. 2 is a view illustrating a foldable electronic device according to an embodiment of the disclosure in an unfolded state.
FIG. 3 is a view illustrating the foldable electronic device according to an embodiment of the disclosure in a folded state.
FIG. 4 is an exploded view illustrating the foldable electronic device according to an embodiment of the disclosure in the unfolded state.
FIG. 5 is an exploded perspective view illustrating a portion of the foldable electronic device in the unfolded state according to an embodiment of the disclosure.
FIG. 6 is a perspective view of a fourth frame according to an embodiment of the disclosure.
FIG. 7 is a view illustrating a portion of the fourth frame according to an embodiment of the disclosure.
FIGS. 8 and 9 are views illustrating a second frame according to an embodiment of the disclosure.
FIGS. 10 and 11 are views illustrating a second frame and a support piece according to an embodiment of the disclosure.
FIG. 12 is a perspective view illustrating a portion of the second frame according to an embodiment of the disclosure.
FIG. 13 is a cross-sectional view illustrating a portion of the foldable electronic device according to an embodiment of the disclosure taken along line D-D' in FIG. 11.
FIG. 14 is a cross-sectional view illustrating a portion of the foldable electronic device according to an embodiment of the disclosure taken along line E-E' in FIG. 11.
FIG. 15 is a cross-sectional view illustrating a portion of the foldable electronic device according to an embodiment of the disclosure taken along line F-F' in FIG. 11.
FIG. 16 is a view illustrating the second frame and the support piece according to various embodiments of the disclosure.
FIG. 17 is a view illustrating the second frame and the support piece according to various embodiments of the disclosure.
FIG. 18 is a perspective view of the support piece according to various embodiments of the disclosure.
FIG. 19 is a cross-sectional view illustrating the second frame and the support piece according to an embodiment of the disclosure taken along line I-I' in FIG. 17.
FIG. 20 is a perspective view of a fourth frame according to various embodiments of the disclosure.
FIG. 21 is a cross-sectional view illustrating a second frame and the fourth frame according to various embodiments of the disclosure taken along line J-J' in FIG. 20.

### [Mode for the Invention]

Hereinafter, various example embodiments of the disclosure disclosed herein will be described in greater detail with reference to the accompanying drawings.

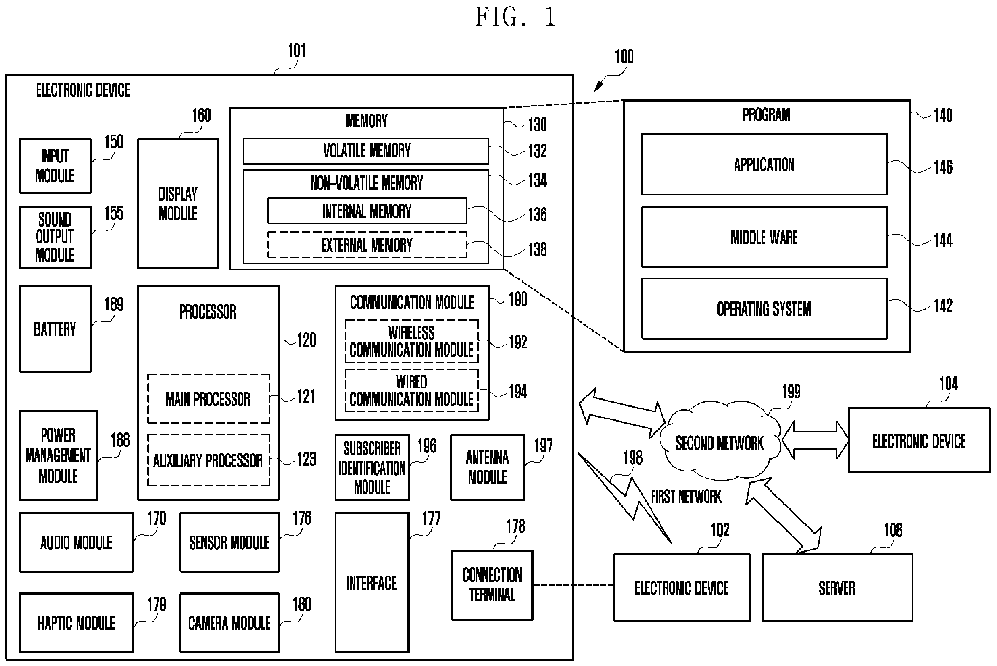

FIG. 1 is a block diagram of an electronic device 101 in a network environment 100 according to an embodiment of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support highspeed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

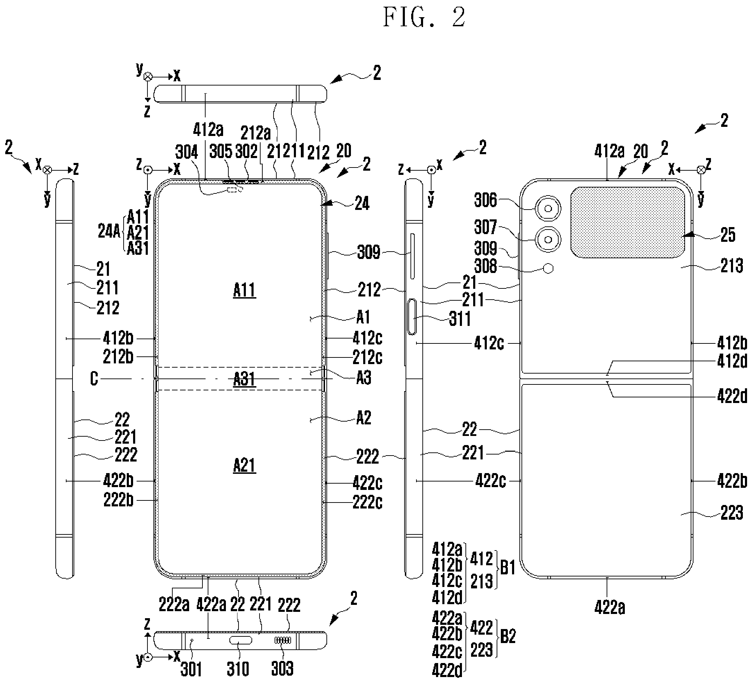

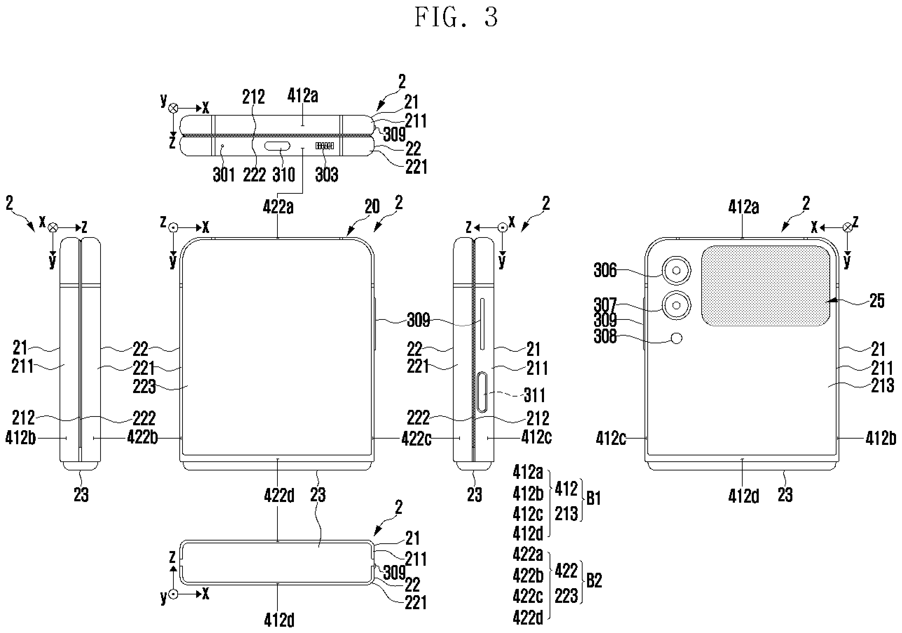

FIG. 2 is a view illustrating a foldable electronic device 2 according to an embodiment of the disclosure in an unfolded state (or an unfolding state or a flat state). FIG. 3 is a view illustrating the foldable electronic device 2 according to an embodiment of the disclosure in a folded state (or a folding state).

Referring to FIGS. 2 and 3, a foldable electronic device 2 may include a foldable housing 20, a first display module (e.g., a flexible display module or a foldable display module) 24, and/or a second display module 25. In various embodiments, the foldable electronic device 2 may be the electronic device 101 of FIG. 1.

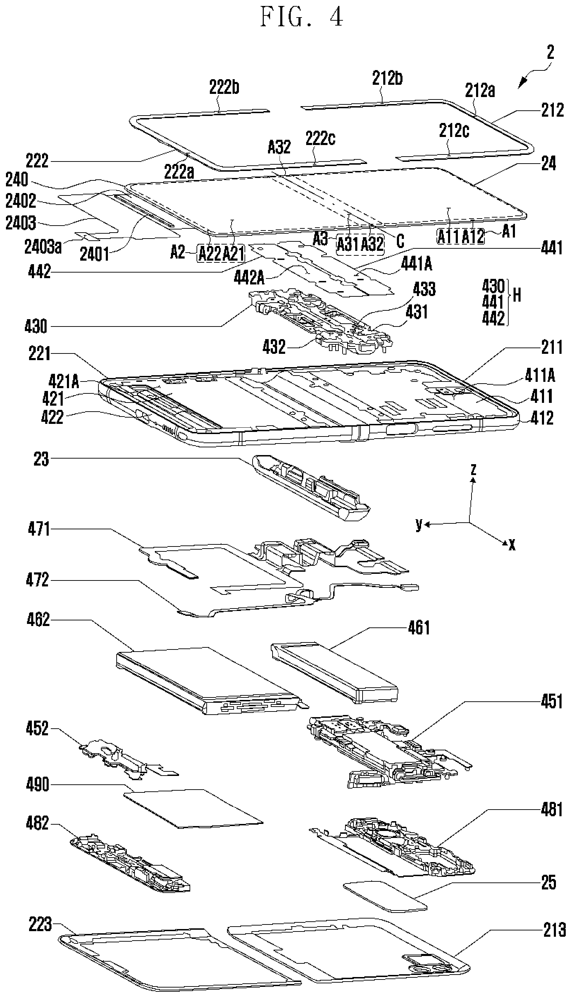

According to an embodiment, the foldable housing 20 may include a first housing (or a first housing portion or a first housing structure) 21, a second housing (or a second housing portion or a second housing structure) 22, a hinge housing 23, and/or a hinge. The first housing 21 and the second housing 22 may be connected via the hinge (e.g., the hinge H in FIG. 4) and mutually rotatable about the hinge. The hinge may include one or more hinge modules (or hinge assemblies) (e.g., the hinge module 430 in FIG. 4).

According to an embodiment, the first display module 24 may include a first area A1, a second area A2, and a third area A3. The first area A1 may be located to correspond to the first housing 21. The second area A2 may be located to correspond to the second housing 22. The third area A3 may be a portion interconnecting the first area A1 and the second area A2 of the first display module 24. The third area A3 may be positioned to correspond to the hinge (e.g., the hinge H of FIG. 4).

According to an embodiment, the first area A1 may be disposed on the first housing 21, and the shape of the first area A1 may be maintained by being supported by the first housing 21. The second area A2 may be disposed on the second housing 22, and the shape of the second area A2 may be maintained by being supported by the second housing 22. The first area A1 and the second area A2 may be provided, for example, to be substantially flat. The unfolded state of the foldable electronic device 2 may be the state in which the third area A3 is disposed to be substantially flat.

According to an embodiment, the display area 24A of the first display module 24 may include, as active areas capable of displaying an image in the first display module 24, a first display area (or a first active area or a first screen area) A11 and is provided by the first area A1, a second display area (or a second active area or a second screen area) A21 provided by the second area A2, and a third display area (or a third active area or a third screen area) A31 provided by the third area A3.

According to an embodiment, when the foldable electronic device 2 is in the unfolded state, the first area A1 and the second area A2 may form an angle of about 180 degrees, and a display area 24A including the first display area A11, the second display area A21, and the third display area A31 may be provided (or disposed) in a substantially flat shape. Due to the relative positions between the first area A1 disposed on the first housing 21 and the second area A2 disposed on the second housing 22 when the foldable electronic device 2 is in the unfolded state, the third area A3 interconnecting the first area A1 and the second area A2 may be disposed flat. When the foldable electronic device 2 is in the unfolded state, the third area A3 may be pulled at the opposite sides thereof by the first area A1 and the second area A2, and the pulling force may be provided to suppress the breakage of the third area A3 while arranging the third area A3 flat. When the foldable electronic device 2 is in the unfolded state, by being pulled by the first area A1 and the second area A2, the third area A3 may be provided with an extending width that is capable of being disposed flat while reducing stress.

The coordinate axes are indicated with reference to the first housing 21. For example, in the foldable electronic device 2, the +z-axis direction may be as a direction in which the surface in which the flat first display A11 is visible is oriented, the x-axis direction may be interpreted as a direction that is parallel to a center line C of the foldable electronic device 2, and the y-axis direction may be interpreted as a direction that is perpendicular to the center line C of the foldable electronic device 2.

According to an embodiment, when the foldable electronic device 2 is in the unfolded state, the hinge (e.g., the hinge H in FIG. 4) may support the third area A3. When an external force (e.g., an external pressure such as a touch input made by using a user's finger or a touch input made by using an electronic pen) is applied to the third area A3 when the foldable electronic device 2 is in the unfolded state, the hinge may contribute to maintaining the third area A3 flat by reducing sagging of the third area A3. The hinge may be configured to reduce the effect of an external impact on the third area A3 when the external impact is applied due to a reason such as a drop when the foldable electronic device 2 is in the unfolded state. When the foldable electronic device 2 is in the unfolded state, the hinge may support the third area A3 such that the third area A3 is capable of being disposed flat without sagging, thereby reducing a crease phenomenon.

According to an embodiment, the foldable electronic device 2 may be provided in an infolding type in which the display area 24A of the first display module 24 is folded inward. The surface of the foldable electronic device 2 in which the display area 24A of the first display module 24 is visible may be interpreted as "the front surface of the foldable electronic device 2", and the surface of the foldable electronic device 2 oriented in the opposite direction to the front surface of the foldable electronic device 2 may be interpreted as "the rear surface of the foldable electronic device 2". The foldable electronic device 2 may be configured such that the front surface or the first display module 24 is foldable inward.

According to an embodiment, FIG. 3 illustrates the foldable electronic device 2 in the fully folded state in which the first housing 21 and the second housing 22 are disposed not to get closer to each other. When the foldable electronic device 2 is in the fully folded state, the first display area A11 and the second display area A21 may be located to face each other, and the third display area A31 (or the third area A3) may disposed in a bent form. When the foldable electronic device 2 is in the fully folded state, the angle between the first housing 21 and the second housing 22 (or the angle between the first display area A11 and the second display area A21) may range from about 0 degrees to about 10 degrees, and the display area 24A may be substantially invisible.

According to an embodiment, although not illustrated, an intermediate state of the foldable electronic device 2 may be a state between the unfolded state and the fully folded state or a less folded state compared with the fully folded state. In the intermediate state in which the angle between the first housing 21 and the second housing 22 is equal to or greater than a certain angle, a use environment in which a user does not have substantial difficulty in using the display area 24A may be provided. Hereinafter, the "folded state of the foldable electronic device 2" described in the disclosure may refer to the fully folded state in contrast to the intermediate state which is the less folded state.

According to an embodiment, when the foldable electronic device 2 is viewed in the unfolded state, the display area 24A of the first display module 24 may be provided in a symmetrical shape with respect to the center line C of the foldable electronic device 2. When the foldable electronic device 2 is viewed in the unfolded state, the center line C may correspond to the middle of a width extending from a first boundary between the first display area A11 and the third display area A31 to a second boundary between the second display area A21 and the third display area A31. The third display area A31 disposed in the bent form when the foldable electronic device 2 is in the folded state may have a substantially symmetrical shape with respect to the center line C of the foldable electronic device 2.

According to an embodiment, when the foldable electronic device 2 is viewed in the unfolded state, the display area 24A of the first display module 24 may have a substantially rectangular shape.

According to an embodiment, the first area A1 of the first display module 24 may include a first display area A11 and a first border area (e.g., the first border area A12 in FIG. 4) extending from the first display area A11. The first border area may be covered by the first housing 21 and may not be exposed to the outside. The second area A2 of the second display module 24 may include a second display area A21 and a second border area (e.g., the second border area A22 in FIG. 4) extending from the second display area A21. The second edge area may be covered by the second housing 22 and may not be exposed to the outside.

According to an embodiment, the third area A3 of the first display module 24 may include a third display area A3 1 and a third border area (e.g., the third border area A32 in FIG. 4) extending from the third display area A31. The third border area may not be exposed to the outside by being covered by a material (or a member) disposed in the third border area. When the foldable electronic device 2 is in the unfolded state, the material disposed in the third border area may be exposed to provide a portion of the exterior of the foldable electronic device 2. The material disposed in the third border area may include a flexible material capable of reducing degradation of flexibility of the third area A3 when the third area A3 is disposed in the bent form in the state in which the foldable electronic device 2 is folded.

According to an embodiment, the first housing 21 may include a first frame (or a first frame structure or a first framework) 211, a third frame 212 disposed on the first frame 211, and/or a first cover 213 disposed on the first frame 211.

According to an embodiment, the first frame 211 may include a first side surface area 412. The first side surface area 412 may be disposed at least partially along an edge of the first area A1 (or the first display area A11) of the first display module 24. The first side surface area 412 may provide at least a portion of the first side surface of the foldable electronic device 2 corresponding to the first area A1 (or the first display area A11) of the foldable electronic device 2.

According to an embodiment, the third frame 212 may cover the first border area (e.g., the first border area A12 in FIG. 4) included in the first area A1 of the first display module 24, and the first border area may not be exposed to the outside. The combination of the first side surface area 412 of the first frame 211 and the third frame 212 may provide a first bezel B1 (or a first side, a first side surface portion, a first side surface structure, or a first side surface bezel structure) surrounding the first display area A11 of the first display module 24 when viewed from above the display area 24A of the foldable electronic device 2 in the unfolded state.

According to an embodiment, the first side surface area 412 of the first frame 211 may include a first partial side surface area 412a, a second partial side surface area 412b, a third partial side surface area 412c, and/or a seventh partial side surface area 412d. The first partial side surface area 412a and the seventh partial side surface area 412d may be substantially parallel to the center line C of the foldable electronic device 2. The first partial side surface area 412a and the seventh partial side surface area 412d may be located to be spaced apart from each other in a direction perpendicular to the center line C of the foldable electronic device 2 (e.g., the y-axis direction) and may be substantially parallel to each other. The seventh partial side surface area 412d may be located closer to the center line C of the foldable electronic device 2 than the first partial side surface area 412a. The seventh partial side surface area 412d may be located on the rear surface side of the foldable electronic device 2 and may be invisible by being covered by the first display module 24 when viewed from above the display area 24A of the foldable electronic device 2 in the unfolded state. The second partial side surface area 412b may interconnect one end of the first partial side surface area 412a and one end of the seventh partial side surface area 412d and may be substantially perpendicular to the center line C of the foldable electronic device 2. The third partial side surface area 412c may interconnect the other end of the first partial side surface area 412a and the other end of the seventh partial side surface area 412d and may be substantially parallel to the second partial side surface area 412b.

According to an embodiment, a first corner where the first partial side surface area 412a and the second partial side surface area 412b are connected and a second corner where the first partial side surface area 412a and the third partial side surface area 412c are connected may be provided in a round or curved shape.

According to an embodiment, the third frame 212 may include a first frame area 212a corresponding to the first partial side surface area 412a of the first frame 211, a second frame area 212b corresponding to the second partial side surface area 412b of the first frame 211, and a third frame area 212c corresponding to the third partial side surface area 412c of the first frame 211. When viewed from above the first display area A11, the first frame area 212a may be substantially parallel to the center line C of the foldable electronic device 2. When viewed from above the first display area A11, the second frame area 212b and the third frame area 212c may be located to be spaced apart from each other in the direction of the center line C of the foldable electronic device 2 (e.g., the x-axis direction) and may be substantially parallel to each other. To correspond to the first corner where the first partial side surface area 412a and the second partial side surface area 412b are connected, the third frame 212 may include a first corner frame area where the first frame area 212a and the second frame area 212b are connected. To correspond to the second corner where the first partial side surface area 412a and the third partial side surface area 412c are connected, the third frame 212 may include a second corner frame area where the first frame area 212a and the third frame area 212c are connected.

According to an embodiment, the second frame area 212b and the third frame area 212c of the third frame 212 may not extend to the third border area A32 (see FIG. 4) of the third area A3 so as not to interfere with (or hinder) the arrangement of the third area A3 of the third area A3 of the first display module 24 in a bent form when the foldable electronic device 2 is switched from the unfolded state to the folded state.

According to various embodiments, the third frame 212 may be interpreted as a separate element from the first housing 21.

According to an embodiment, the first frame 211 may include a first support (e.g., the first support 411 in FIG. 4) extending from or connected to the first side surface area 412. The first area A1 of the first display module 24 may be disposed on the first support, and the first support may support the first area A1. The first area A1 and the first cover 213 may be located on opposite sides of each other with the first support of the first frame 211 interposed therebetween. The first side surface area 412 of the first frame 211 may be disposed to at least partially surround a space between the first area A1 of the first display module 24 and the first cover 213. The first display area A11 of the first area A1 may provide one surface (e.g., the first front surface or the first front area) among the outer surfaces of the foldable electronic device 2, and the first cover 213 may provide the other surface (e.g., the first rear surface or the second rear surface area) oriented in a substantially opposite direction to the first display area A11 among the outer surfaces of the foldable electronic device 2. The first cover 213 is an element that provides a first rear surface corresponding to the first housing 21 among the rear surfaces of the foldable electronic device 2, and may be referred to as a "first back cover". Various electrical components (or electronic components) such as a printed circuit board or a battery may be disposed on the first support between the first support of the first frame 211 and the first cover 213.

According to an embodiment, the second housing 22 may include a second frame (or a second frame structure or a second framework 221), a fourth frame 222 disposed on the second frame 221, and/or a second cover 223 disposed on the second frame 221.

According to an embodiment, the second frame 221 may include a second side surface area 422. The second side surface area 422 may be disposed at least partially along an edge of the second area A2 (or the second display area A21) of the first display module 24. The second side surface area 422 may provide at least a portion of the second side surface of the foldable electronic device 2 corresponding to the second area A2 (or the second display area A21) of the foldable electronic device 2.

According to an embodiment, the fourth frame 222 may cover the second border area (e.g., the second border area A22 in FIG. 4) included in the second area A2 of the first display module 24, and the second border area may not be exposed to the outside. The combination of the second side surface area 422 of the second frame 221 and the fourth frame 222 may provide a second bezel B2 (or a second side, a second side surface portion, a second side surface structure, or a second side surface bezel structure) surrounding the second display area A21 of the first display module 24 when viewed from above the display area 24A of the foldable electronic device 2 in the unfolded state.

According to an embodiment, the second side surface area 422 of the second frame 221 may include a fourth partial side surface area 422a, a fifth partial side surface area 422b, a sixth partial side surface area 422c, and/or an eighth partial side surface area 422d. The fourth partial side surface area 422a and the eighth partial side surface area 422d may be substantially parallel to the center line C of the foldable electronic device 2. The fourth partial side surface area 422a and the eighth partial side surface area 422d may be located to be spaced apart from each other in a direction perpendicular to the center line C of the foldable electronic device 2 (e.g., the y-axis direction) and may be substantially parallel to each other. The eighth partial side surface area 422d may be located closer to the center line C of the foldable electronic device 2 than the fourth partial side surface area 422a. The eighth partial side surface area 422d may be located on the rear surface side of the foldable electronic device 2 and may be invisible by being covered by the first display module 24 when viewed from above the display area 24A of the foldable electronic device 2 in the unfolded state. The fifth partial side surface area 422b may interconnect one end of the fourth partial side surface area 422a and one end of the eighth partial side surface area 422d and may be substantially perpendicular to the center line C of the foldable electronic device 2. The sixth partial side surface area 422c may interconnect the other end of the fourth partial side surface area 422a and the other end of the eighth partial side surface area 422d and may be substantially parallel to the fifth partial side surface area 422b.

According to an embodiment, a third corner where the fourth partial side surface area 422a and the fifth partial side surface area 422b are connected and a fourth corner where the fourth partial side surface area 422a and the sixth partial side surface area 422c are connected may be provided in a round or curved shape.

According to an embodiment, the fourth frame 222 may include a fourth frame area 222a corresponding to the fourth partial side surface area 422a of the second frame 221, a fifth frame area 222b corresponding to the fifth partial side surface area 422b of the second frame 221, and a sixth frame area 222c corresponding to the sixth partial side surface area 422c of the second frame 221. When viewed from above the second display area A21, the fourth frame area 222a may be substantially parallel to the center line C of the foldable electronic device 2. When viewed from above the second display area A21, the fifth frame area 222b and the sixth frame area 222c may be located to be spaced apart from each other in the direction of the center line C of the foldable electronic device 5 (e.g., the x-axis direction) and may be substantially parallel to each other. To correspond to the third corner where the fourth partial side surface area 422a and the fifth partial side surface area 422b are connected, the fourth frame 222 may include a third corner frame area where the fourth frame area 222a and the fifth frame area 222b are connected. To correspond to the fourth corner where the fourth partial side surface area 422a and the sixth third partial side surface area 422c are connected, the fourth frame 222 may include a fourth corner frame area where the fourth frame area 222a and the sixth frame area 222c are connected.

According to an embodiment, the fifth frame area 222b and the sixth frame area 222c of the fourth frame 222 may not extend to the third border area A32 (see FIG. 4) of the third area A3 so as not to interfere with (or hinder) the arrangement of the first display module 24 in a bent form when the foldable electronic device 2 is switched from the unfolded state to the folded state.

According to various embodiments, the fourth frame 222 may be interpreted as a separate element from the second housing 22.

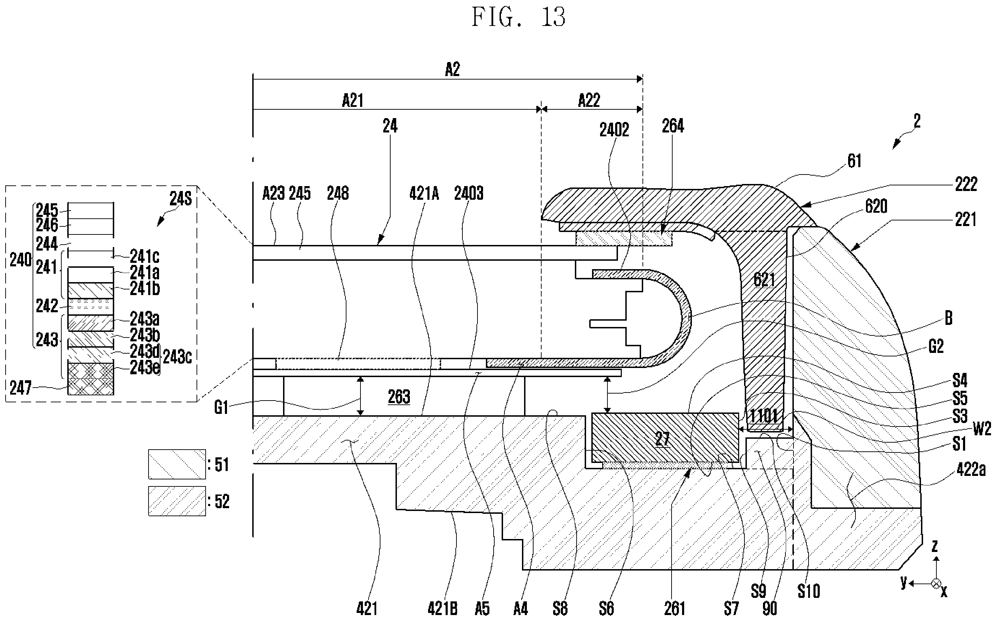

According to an embodiment, the second frame 221 may include a second support (e.g., the second support 421 in FIG. 4) extending from or connected to the second side surface area 422. The second area A2 of the first display module 24 may be disposed on the second support, and the second support may support the second area A2. The second area A2 and the second cover 223 may be located on opposite sides of each other with the second support of the second frame 221 interposed therebetween. The second side surface area 422 of the second frame 221 may be disposed to at least partially surround a space between the second area A2 of the first display module 24 and the second cover 223. The second display area A21 of the second area A2 may provide one surface (e.g., the second front surface or the second front area) (e.g., see the second front surface A23 in FIG. 13) among the outer surfaces of the foldable electronic device 2, and the second cover 223 may provide the other surface (e.g., the second rear surface or the second rear surface area) oriented in a substantially opposite direction to the second display area A21 among the outer surfaces of the foldable electronic device 2. The second cover 223 is an element that provides a second rear surface corresponding to the second housing 22 among the rear surfaces of the foldable electronic device 2, and may be referred to as a "second back cover". Various electrical components (or electronic components) such as a printed circuit board or a battery may be disposed on the second support between the second support of the second frame 221 and the second cover 223.

According to an embodiment, when the foldable electronic device 2 is in the folded state, the first bezel B1 of the first housing 21 and the second bezel B2 of the second housing 22 may be aligned to overlap each other.

According to an embodiment, when the foldable electronic device 2 is in the folded state, the third frame 212 of the first bezel B1 and the fourth frame 222 of the second bezel B2 may be aligned to overlap each other. When the foldable electronic device 2 is in the folded state, the first frame area 212a of the third frame 212 and the fourth frame area 222a of the fourth frame 222 may be aligned to overlap each other. When the foldable electronic device 2 is in the folded state, the second frame area 212b of the third frame 212 and the fifth frame area 222b of the fourth frame 222 may be aligned to overlap each other. When the foldable electronic device 2 is in the folded state, the third frame area 212c of the third frame 212 and the sixth frame area 222c of the fourth frame 222 may be aligned to overlap each other.

According to various embodiments, the third frame 212 and/or fourth frame 222 may include a buffer material or a flexible material to alleviate collision between the first housing 21 and the second housing 22 when the foldable electronic device 2 is switched from the unfolded state to the folded stat.

According to an embodiment, the hinge housing (or the hinge cover) 23 may be coupled with a hinge module (e.g., the hinge module 430 in FIG. 4). When the foldable electronic device 2 is switched from the unfolded state to the folded state, due to a change in the relative position between the first frame 211 and the second frame 221 connected to each other via the hinge (e.g., the hinge H in FIG. 4) and a change in the state of the hinge module (e.g., the hinge module 430 in FIG. 4) coupled with the hinge housing 23, a gap between the seventh partial side surface area 412d included in the first side surface area 412 of the first frame 211 and the eighth partial side surface area 422d included in the second side surface area 422 of the second frame 221 may be opened on the opposite side to the third display area A3 of the first display module 24, and the hinge housing 23 may be exposed to the outside through the opened gap. When the foldable electronic device 2 is switched from the folded state to the unfolded state, due to a change in the relative position between the first frame 211 and the second frame 221 connected to each other via the hinge and a change in the state of the hinge module coupled with the hinge housing 23, the gap between the seventh partial side surface area 412d included in the first side surface area 412 of the first frame 211 and the eighth partial side surface area 422d included in the second side surface area 422 of the second frame 221 may be closed on the opposite side to the third display area A31 of the first display module 24, and the hinge housing 23 may be located in an inner space defined due to the combination of the first frame 211 and the second frame 221 not to be exposed to the outside.

According to an embodiment, the second display module 25 may be disposed in a direction different from that of the first display module 24. The second display module 25 may provide a display area (or a screen area) which is oriented, for example, in a direction opposite to the first display area ① of the first display module 24. In an embodiment, the first cover 213 may include a light transmission area (or an opening) provided to correspond to the second display module 25, and the second display module 25 may be visible through the light transmission area of the first cover 213. The second display module 25 may be provided in a form in which a transparent cover (a transparent plate, such as a window, covering and protecting a display) is omitted and may be coupled to the first cover 213 via a transparent optical adhesive material (e.g., an optical clear adhesive (OCA), an optical clear resin (OCR), or a super view resin (SVR).

According to an embodiment, in the folded state, the foldable electronic device 2 may be configured to display an image through the second display module 25 instead of the first display module 24.

According to various embodiments, the first cover 213 may include an opening, and the second display module 25 may be located in the opening of the first cover 213. A portion of the exterior of the foldable electronic device 2 may be provided by a transparent cover (a transparent plate, such as a window, covering and protecting the display) of the second display module 25.

According to an embodiment, the foldable electronic device 2 may include one or more sound input modules (e.g., the input module 150 in FIG. 1), one or more sound output modules (e.g., the sound output module 155 in FIG. 1), one or more sensor modules (e.g., the sensor module 176 in FIG. 1), one or more camera modules (e.g., a first camera module 305, a second camera module 306, and a third camera module 307), one or more light-emitting modules (e.g., a light-emitting module 308), one or more connection terminals (e.g., a first connection terminal 310 and a second connection terminal 311), and/or one or more key input modules (e.g., the input module 150 in FIG. 1). According to various embodiments, at least one of the above-mentioned components may be omitted from the foldable electronic device 2 or other components may be additionally included in the foldable electronic device 2. The positions or the numbers of components included in the foldable electronic device 2 may vary without being limited to the illustrated example.

According to an embodiment, one of the one or more sound input modules may include a microphone (not separately illustrated) disposed inside the foldable electronic device 2 to correspond to a microphone hole 301 provided in the exterior (e.g., the second side surface) of the foldable electronic device 2. The positions or the numbers of microphones and corresponding microphone holes 301 may vary without being limited to the illustrated example.

According to an embodiment, one of the one or more sound output modules may include a first speaker for communication (e.g., a receiver for communication) (not illustrated separately) located inside the foldable electronic device 2 to correspond to the first speaker hole 302 provided in the exterior (e.g., the first front surface) of the foldable electronic device 2. One of the one or more sound output modules may include a second speaker (not illustrated separately) for multimedia playback (or recording and playback) located inside the foldable electronic device 2 to correspond to the second speaker hole 303 provided in the exterior (e.g., the second side surface) of the foldable electronic device 2. The positions or the numbers of first speakers and corresponding first speaker holes 302 may vary without being limited to the illustrated example. The positions or the numbers of second speakers and corresponding second speaker holes 303 may vary without being limited to the illustrated example.

According to various embodiments, the first speakers may include a piezo speaker, and the first speaker holes 302 may be omitted. In various embodiments, the second speakers may include a piezo speaker, and the second speaker holes 303 may be omitted.

According to various embodiments, a single hole may be provided to replace the microphone holes 301 and the speaker holes (e.g., the first speaker holes 302 or the second speaker holes 303) (not illustrated separately).

According to an embodiment, one of the one or more sensor modules may include an optical sensor (e.g., a proximity sensor or an illuminance sensor) 304 located inside the electronic device 2 to correspond to the exterior (e.g., the first front surface) of the foldable electronic device 2. The optical sensor 304 may be aligned with an opening provided in the flexible display of the first display module 24. In various embodiments, the optical sensor 304 may be at least partially inserted into the opening in the flexible display. External light may reach the optical sensor 304 through the transparent cover (e.g., a flexible transparent plate, such as a window, covering and protecting the flexible display) of the first display module 24 and the opening in the flexible display. The opening in the flexible display may be a through hole or a notch (not illustrated separately).

According to various embodiments, the optical sensor 304 may be located on the rear surface of the first display area A11 or below or beneath the first display area A11. The optical sensor 304 or the position of the optical sensor 304 may not be visually distinct (or exposed). In various embodiments, the optical sensor 304 may be aligned with a recess provided in the rear surface of the first display area A11. In various embodiments, the optical sensor 304 may be at least partially inserted into the recess in the first display area A11. The optical sensor 304 may overlap the first display area A11 when viewed from above the first display area A11. The optical sensor 304 may execute a sensing function without being visually exposed.

According to various embodiments, a portion of the first display area A11 at least partially overlapping the optical sensor 304 may include a pixel structure and/or a wiring structure different from those of other portions of the first display area A11. For example, a portion of the first display area A11 at least partially overlapping the optical sensor 304 may have a pixel density (e.g., the number of pixels per unit area) different from those of other portions of the first display area A11. In various embodiments, multiple pixels may not be disposed in a portion of the first display area A11 that at least partially overlaps the optical sensor 304.

According to various embodiments, the positions or the numbers of optical sensors 304 may vary without being limited to the illustrated example.

According to various embodiments, the foldable electronic device 2 may include biometric sensors (e.g., a fingerprint sensor) (not illustrated separately) located on the rear surface of the display area 24A or beneath or below the display area 24A. The biometric sensors may be implemented as an optical sensor, an electrostatic sensor, or an ultrasonic sensor, and the positions or the number of biometric sensors may vary.

According to an embodiment, the one or more camera modules may include a first camera module 305, a second camera module 306, and/or a third camera module 307. The first camera module 305 (e.g., a front camera module) may be located inside the foldable electronic device 2 to correspond to a front surface (e.g., the first front surface) of the foldable electronic device 2. The second camera module 306 (e.g., the first rear camera module) and the third camera module 307 (e.g., the second rear camera module) may be located inside the foldable electronic device 2 to correspond to the rear surface (e.g., the first rear surface) of the foldable electronic device 2. In an embodiment, the first camera module 305, the second camera module 306, and the third camera module 307 may be disposed in the first housing 21.

According to an embodiment, the first camera module 305 may be aligned with an opening provided in the flexible display of the first display module 24. According to various embodiments, the first camera module 305 may be at least partially inserted into the opening in the flexible display. External light may reach the optical sensor 304 through the transparent cover (e.g., a flexible transparent plate, such as a window, covering and protecting the flexible display) of the first display module 24 and the opening in the flexible display. The opening in the flexible display may be a through hole or a notch (not illustrated separately).

According to various embodiments, the first camera module 305 may be located on the rear surface of the first display area A11 or below or beneath the first display area A11. The first camera module 305 may include, for example, a hidden display rear camera (e.g., an under display camera (UDC)). In various embodiments, the first camera module 305 may be located in alignment with the recess provided in the rear surface of the first display area A11. According to various embodiments, the first camera module 305 may be at least partially inserted into the recess in the first display area A11. By being disposed to overlap at least a portion of the first display area A11, the first camera module 305 may acquire an image of an external subject without being visually exposed to the outside.

According to various embodiments, a partial area of the first display area A11 at least partially overlapping the first camera module 305 may include a pixel structure and/or wiring structure different from those of other areas. For example, a portion of the first display area A11 at least partially overlapping the first camera module 305 may have a pixel density (e.g., the number of pixels per unit area) different from those of other portions of the first display area A11. The pixel structure and/or the wiring structure disposed in a portion of the first display area A11 that at least partially overlaps the first camera module 305 may suppress light loss between the outside and the first camera module 305. In various embodiments, pixels may not be disposed in a portion of the first display area A11 that at least partially overlaps the first camera module 305.

According to various embodiments, the second camera module 306 or the third camera module 307 may include lenses having different angles of view. The electronic device 2 may be implemented to change the angle of view of the second camera module 306 or the third camera module 307 executed in the electronic device 2 based on a user's selection.

According to various embodiments, the second camera module 306 and the third camera module 307 may have different attributes (e.g., angles of view) or functions. The second camera module 306 or the third camera module 307 may include a wide-angle camera, a telephoto camera, a color camera, a monochrome camera, or an infrared (IR) camera (e.g., a time of flight (TOF) camera or a structured light camera). In various embodiments, the IR camera may be operated as at least a part of a sensor module.

According to an embodiment, the light-emitting module 308 may be located inside the foldable electronic device 2 to correspond to the rear surface (e.g., the first rear surface) of the foldable electronic device 2. The light-emitting modules 308 may be disposed in the first housing 21 to correspond to the first cover 213. The light-emitting modules 308 may operate as a light source for the second camera module 306 or the third camera module 307.

According to an embodiment, one of the one or more connection terminals may include a first connector (or a first interface terminal) (not illustrated separately) located inside the foldable electronic device 2 to correspond to a first connector hole 310 provided in the exterior (e.g., the second side surface) of the foldable electronic device 2. The first connector may be, for example, a universal serial bus (USB) connector or a high-definition multimedia interface (HDMI) connector. The foldable electronic device 2 may transmit and/or receive data and/or power with respect to an external electronic device electrically connected to the first connector. The positions or the number of first connector holes 310 may vary without being limited to the illustrated example.

According to an embodiment, one of the one or more connection terminals may include a second connector (or a second interface terminal) (not illustrated separately) located inside the foldable electronic device 2 to correspond to a first connector hole 310 provided in the exterior (e.g., the first side surface) of the foldable electronic device 2. For example, an external storage medium (e.g., a subscriber identity module (SIM) card) or a memory card (e.g., a secure digital memory (SD) card) may be connected to the second connector. The second connector hole may be covered by the cover 311.

According to an embodiment, the one or more key input modules may include a key 309 located in the exterior (e.g., the first side surface) of the electronic device 2 and a key signal generator located inside the foldable electronic device 2 to correspond to the key 309. The positions or the number of keys 309 may vary without being limited to the illustrated example.

According to various embodiments, the foldable electronic device 2 may include a detachable pen input device (e.g., an electronic pen, a digital pen, or a stylus pen) (not illustrated separately). The pen input device may be implemented to be inserted into, for example, the inner space of the first housing 21 or the second housing 22. As another example, the pen input device may be attached to or detached from the hinge housing 23. The hinge housing 23 may include a recess, and the pen input device may fit into the recess.

The foldable electronic device 2 may further include various components depending on the provided shape thereof. These components have various variations depending on the convergence trend of foldable electronic devices 2, so it is impossible to enumerate all of the components, but components equivalent to the above-mentioned components may be further included in the foldable electronic device 2. In various embodiments, specific components may be excluded from the above components or replaced with other components depending on the provided shape of an electronic device.

FIG. 4 is an exploded perspective view of the foldable electronic device 2 according to an embodiment of the disclosure in the unfolded state.

Referring to FIG. 4, the foldable electronic device 2 may include a first frame 211, a third frame 212, a first cover 213, a second frame 221, a fourth frame 222, a second cover 223, a hinge cover 23, a first display module 24, a second display module 25, a hinge H, a first printed circuit board 451, a second printed circuit board 452, a first battery 461, a second battery 462, a second flexible printed circuit board 471, a third flexible printed circuit board 472, a first inner supporter 481, a second inner supporter 482, and/or an antenna structure 490.

According to an embodiment, the first frame 211 may include a first support 411 and a first side surface area 412. The first frame 211 may be provided in an integrated form including, for example, the first support 411 and the first side surface area 412. The first support 411 is an internal structure located inside the foldable electronic device 2 to correspond to the first housing 21 and may be referred to as various other terms, such as a "first bracket", a "first supporter", and a "first support member", or a "first support structure".

According to an embodiment, the second frame 221 may include a second support 421 and a second side surface area 422. The second frame 221 may be provided in an integrated form including, for example, the second support 421 and the second side surface area 422. The second support 421 is an internal structure located inside the foldable electronic device 2 to correspond to the second housing 22 and may be referred to as various other terms, such as a "second bracket", a "second supporter", and a "second support member", or a "second support structure".

According to an embodiment, at least a portion of the first frame 211 and/or at least a portion of the second frame 221 may be made of a metal material and/or a non-metal material (e.g., polymer). Electrical components (or electronic components) or various members related to the electrical components may be disposed on or supported by the first frame 211 or the first support 411. The first support 411 may include a first support area 411A and a third support area (not illustrated) oriented in a direction substantially opposite to the first support area 411A. The first area A1 of the first display module 24 may be disposed in the first support area 411A of the first support 411. Various components such as the first printed circuit board 451 or the first battery 461 may be disposed in the third support area. The second support 421 may include a second support area 421A and a fourth support area (e.g., the fourth support area 421B in FIG. 13) oriented in a direction substantially opposite to the second support area 421A. The second area A2 of the first display module 24 may be disposed in the second support area 421A of the second support 421. Various components such as the second printed circuit board 452 or the second battery 462 may be disposed in the fourth support area.

According to an embodiment, the first display area A1 may be disposed on the first support 411 and the second display area A2 may be disposed on the second support 421 via various adhesive materials (or gluing materials) such as a heat-reactive adhesive material (or a heat-reactive gluing material), a light-reactive gluing material (or a light-reactive adhesive material), an ordinary gluing agent (or an ordinary adhesive), and/or a double-sided tape.

According to an embodiment, the first area A1 of the first display module 24 may include a first display area A11 and a first border area A12. The second area A2 of the first display module 24 may include a second display area A21 and a second border area A22. The third area A3 of the first display module 24 may include a third display area A31 and a third border area A32.

According to an embodiment, the third frame 212 may be disposed on the first frame 211 or coupled with the first frame 211. The third frame 212 may cover the first border area A12 included in the first area A1 of the first display module 24, and the first border area A12 may not be exposed to the outside. The third frame 212 may include a first frame area 212a, a second frame area 212b, and/or a third frame area 212c. The first border area A12 included in the first area A1 of the first display module 24 may include a first partial border area corresponding to the first frame area 212a, a second partial border area corresponding to the second frame area 212b, and/or a third partial border area corresponding to the third frame area 212c.

According to an embodiment, the fourth frame 222 may be disposed on the second frame 221 or coupled with the second frame 221. The fourth frame 222 may cover the second border area A22 included in the second area A2 of the first display module 24, and the second border area A22 may not be exposed to the outside. The fourth frame 222 may include a fourth frame area 222a, a fifth frame area 222b, and/or a sixth frame area 222c. The second border area A22 included in the second area A2 of the first display module 24 may include a fourth partial border area corresponding to the fourth frame area 222a, a fifth partial border area corresponding to the fifth frame area 222b, and/or a sixth partial border area corresponding to the sixth frame area 222c.

According to an embodiment, the third frame 212 and/or the fourth frame 222 may include a non-conductive material (e.g., a non-metal material).

According to various embodiments, the third frame 212 and/or the fourth frame 222 may include a conductive material (or a metal material).

According to an embodiment, the hinge H may include a hinge module 430, a first plate (or a first wing plate 441, and/or a second plate (or a second wing plate) 442.

According to an embodiment, the hinge module 430 may include a first bracket 431, a second bracket 432, and/or a bracket connector 433. The first bracket 431 may be disposed in or coupled to the first support area 411A of the first frame 211 through, for example, screw fastening. The second bracket 432 may be disposed in or coupled to the second support area 421A of the second frame 221 through, for example, screw fastening. The bracket connector 433 may interconnect the first bracket 431 and the second bracket 432. The first bracket 431 and the second bracket 432 may be rotatable relative to the bracket connector 433.

According to an embodiment, the bracket connector 433 of the hinge module 430 may be configured such that the first frame 211 to which the first bracket 431 is fixed and the second frame 221 to which the second bracket 432 is fixed are rotatable by the same angle in opposite directions. The bracket connector 433 may be configured such that the first frame 211 to which the first bracket 431 is fixed and the second frame 221 to which the second bracket 432 is fixed may be maintained after rotating by at least one predetermined angle. The bracket connector 433 may have, for example, a free-stop function. The bracket connector 433 may be configured to provide a force for mutual rotation of the first frame 211 to which the first bracket 431 is fixed and the second frame 221 to which the second bracket 432 is fixed. The bracket connector 433 may be provided as a combination of, for example, at least one shaft, at least one cam gear, and/or at least one compression spring providing elasticity.

According to an embodiment, the first plate 441 may be located to correspond to the first frame 211, and the second plate 442 may be located to correspond to the second frame 221. The first plate 441 and the second plate 442 may have, for example, a first width in the direction of the center line C of the foldable electronic device 2 (e.g., the x-axis direction) and a second width in a direction perpendicular to the above-mentioned direction, wherein the first width is relatively greater than the second width. The first plate 441 and the second plate 442 may overlap the hinge module 430. The first plate 441 and the second plate 442 may be coupled to the hinge module 430.

According to an embodiment, the first plate 441 and the second plate 442 may be connected to the bracket connector 433 of the hinge module 430. The first plate 441 may include a first surface 441A provided to correspond to the third display area A3 of the first display module 24. The second plate 442 may include a second surface 442A provided to correspond to the third display area A3 of the first display module 24. When the foldable electronic device 2 is in the unfolded state (see FIG. 2), the first surface 441A of the first plate 441 may support a portion of the third display area A3, and the second surface 442A of the second plate 442 may support a portion of the third display area A3. The first surface 441A of the first plate 441 may include a flat surface capable of supporting one side area of the third display area A3 with respect to the center line C of the foldable electronic device 2 when the foldable electronic device 2 is in the unfolded state. The second surface 442A of the second plate 442 may include a flat surface capable of supporting the other side area of the third display area A3 with respect to the center line C of the foldable electronic device 2 when the foldable electronic device 2 is in the unfolded state. When the foldable electronic device 2 is in the unfolded state, the first surface 441A of the first plate 441 and the second surface 442A of the second plate 442 may substantially form an angle of about 180 degrees and may be disposed without a substantial difference in height. When the foldable electronic device 2 is in the unfolded state, even if an external force (e.g., an external pressure such as a touch input made by using a user's finger or a touch input made by using an electronic pen) is applied to the third display area A3, the third display area A3 may remain flat by being supported by the plate 441 and the second plate 442.

According to an embodiment, the bracket connector 433 of the hinge module 430 may include a center plate (not illustrated separately) aligned to correspond to the center line C of the foldable electronic device 2. When the foldable electronic device 2 is in the unfolded state of the foldable electronic device 2, the center plate may support a portion of the third display area A3 of the first display 24 that corresponds to a gap between the first surface 441A of the first plate 441 and the second surface 442A of the second plate 442. The center plate may suppress or prevent a sagging phenomenon or a crease phenomenon of the portion of the third area A3 corresponding to the gap between the first surface 441A of the first plate 441 and the second surface 442A of the second plate 442 when the foldable electronic device 2 is in the unfolded state.

According to an embodiment, the hinge H may be configured to provide a space in which the third area A3 of the first display module 24 may be disposed in a bent shape capable of reducing bending stress when the foldable electronic device 2 is switched from the unfolded state (see FIG. 2) to the folded state (see FIG. 3). The hinge H may be configured to provide a space in which the third area A3 may be disposed in a bent shape capable of suppressing a buckling phenomenon when the foldable electronic device 2 is switched from the unfolded state to the folded state. In an embodiment, when the foldable electronic device 2 is switched from the unfolded state to the folded state, the third area A3 may be disposed in a droplet shape or a dumbbell shape capable of reducing breakage or permanent deformation. When the foldable electronic device 2 is in the folded state, the third area A3 may be disposed in a bent shape capable of reducing a collision (e.g., bending stress) between compressive stress generated in one side area of the third area A3 and tensile stress generated in the other side area of the third area A3 with reference to a neutral plane inside the third area A3.

According to an embodiment, the second flexible printed circuit board 471 and the third flexible printed circuit board 472 may be disposed across the hinge H. The second flexible printed circuit board 471 and/or the third flexible printed circuit board 472 may electrically interconnect a first electrical element (e.g., the first printed circuit board 451) located on the first frame 211 and a second electrical element (e.g., the second printed circuit board 452) located on the second frame 221.

According to an embodiment, the third flexible printed circuit board 472 may be a flexible RF cable (FRC). The second printed circuit board 452 may include an antenna radiator or may be electrically connected to an antenna radiator included in the foldable electronic device 2. A wireless communication circuit (e.g., the wireless communication module 192 in FIG. 1) may be disposed on the first printed circuit board 451. The wireless communication circuit may be electrically connected to the antenna radiator via the third flexible printed circuit board 472. The wireless communication circuit may transmit a radiation current (or a radio signal, an RF signal, or an electromagnetic signal) to the antenna radiator via the third flexible printed circuit board 472. The wireless communication circuit may process a signal (or an RF signal) transmitted or received via the antenna radiator.

According to an embodiment, the first inner supporter 481 may be located between the first cover 213 and the first support 411 of the first frame 211. The first inner supporter 481 may be coupled to the first support 411 through screw fastening. The first inner supporter 481 may cover and protect components such as the first printed circuit board 451 or the first battery 461 disposed between the first support 411 and the first cover 213.

According to various embodiments, the first inner supporter 481 may include a non-metal material, and a conductive pattern used as an antenna radiator may be disposed on or included in the first inner supporter 481.

According to various embodiments, the first frame 211 may be referred to as a "first front case", and the first inner supporter 481 may be referred to as a "first rear case".

According to an embodiment, the second inner supporter 482 may be located between the second cover 223 and the second support 421 of the second frame 221. The second inner supporter 482 may be coupled to the second supporter 421 through screw fastening. The second inner supporter 482 may cover and protect components such as the second printed circuit board 452 or the second battery 462 disposed between the second support 421 and the second cover 223.

According to various embodiments, the second inner supporter 482 may include a non-metal material, and a conductive pattern used as an antenna radiator may be disposed on or included in the second inner supporter 482.

According to various embodiments, the second frame 221 may be referred to as a "second front case", and the second inner supporter 482 may be referred to as a "second rear case".

According to an embodiment, the antenna structure 490 may be at least partially located between the second support 421 of the second frame 221 and the second cover 223. The antenna structure 490 may be implemented in the form of, for example, a film such as a flexible printed circuit board. The antenna structure 490 may include at least one conductive pattern used as a loop-type radiator. In an embodiment, the at least one conductive pattern may include a planar spiral conductive pattern (e.g., a planar coil or a pattern coil). The antenna structure 490 may be electrically connected to the first printed circuit board 451 via an electrical path such as a flexible printed circuit board. In an embodiment, the at least one conductive pattern included in the antenna structure 490 may be electrically connected to a communication circuit (e.g., the wireless communication module 192 in FIG. 1) disposed on the first printed circuit board 451. For example, the at least one conductive pattern may be utilized for short-range wireless communication such as near-field communication (NFC). As another example, the at least one conductive pattern may be utilized for magnetic secure transmission (MST) for transmitting and/or receiving a magnetic signal. In an embodiment, the at least one conductive pattern included in the antenna structure 490 may be electrically connected to a power transmission/reception circuit disposed on the first printed circuit board 451. The power transmission/reception circuit may wirelessly receive power from an external electronic device or wirelessly transmit power to an external electronic device by using the at least one conductive pattern included in the antenna structure 490. The power transmission/reception circuit may include a power management module, for example, a power management integrated circuit (PMIC) or a charger integrated circuit (IC). The power transmission/reception circuit may charge the first battery 461 and/or the second battery 462 by using the power wirelessly received by using the conductive pattern.

According to an embodiment, the second display module 25 may be located in the inner space of the first housing 21 to correspond to the first cover 213. The first cover 213 may include a light transmission area (or an opening) provided to correspond to the second display module 25. For example, the second display module 25 may be disposed on or coupled to the first inner supporter 481, and may be supported on the first inner supporter 481 and located in the light transmission area (or the opening) in the first cover 213. In various embodiments, the second display module 25 may be coupled to the first cover 213.

According to an embodiment, at least a portion of a conductive portion included in the first frame 211 may be used as at least a portion of an antenna radiator (or a radiating portion). For example, at least a portion of a conductive portion included in the first side surface area 412 may be used as at least a portion of an antenna radiator (or a radiating portion) configured to transmit (or radiate) electromagnetic signals (or electromagnetic waves) to the outside or to receive electromagnetic signals from the outside.

According to an embodiment, at least a portion of a conductive portion included in the second frame 221 may be used as at least a portion of an antenna radiator (or a radiating portion). For example, at least a portion of a conductive portion included in the second side surface area 422 may be used as at least a portion of an antenna radiator (or a radiating portion) configured to transmit (or radiate) electromagnetic signals (or electromagnetic waves) to the outside or to receive electromagnetic signals from the outside.

According to an embodiment, the first display module 24 may include a flexible display 240, a display driving circuit 2401, an extension 2402, and/or a first flexible printed circuit board 2403.

According to an embodiment, the flexible display 240 may provide a first area A1, a second area A2, and a third area A3.

According to an embodiment, the display driving circuit 2401 may serve as a signal path between the flexible display 240 and a processor (e.g., the processor 120 in FIG. 1) disposed on the first printed circuit board 451. The display driving circuit 2401 may control pixels through thin film transistors (TFTs) included in the flexible display 240. The display driving circuit 2401 may have, for example, a function of making a color difference by adjusting the amounts of red, green, blue (RGB) signals of pixels. In various embodiments, the display driving circuit 2401 may be configured to operate in response to a red, green, blue, white (RGBW) scheme in which a white pixel is added to an RGB pixel. The display driving circuit 2401 may include, for example, a display drive integrated circuit (DDI) or a DDI chip.

According to various embodiments, the display driving circuit 2401 may be a DDI package. The display driving circuit 2401 may include a DDI (or a DDI chip), a timing controller (T-CON), a graphics RAM (GRAM), or a power driver. In various embodiments, the graphics RAM may be omitted or may be implemented with a memory provided separately from the display driving circuit 2401. The timing controller may convert a data signal input from a processor (e.g., the processor 120 in FIG. 1) into a signal required by the DDI. The timing controller may adjust input data information into signals suitable for a gate driver (or a gate IC) and a source driver (or a source IC) of the DDI. The graphics RAM may serve as a memory that temporarily stores data input to the driver (or IC) of the DDI. The graphics RAM may store an input signal and send the signal back to the driver of the DDI. At this time, the graphics RAM may interact with the timing controller to process the signal. The power generating circuit may generate a voltage for driving the flexible display 240 to provide a required voltage to the gate driver and the source driver of the DDI.

According to an embodiment, the display driving circuit 2401 may be located between the second area A2 of the flexible display 240 and the second support 421 of the second frame 221. The display driving circuit 2401 may be disposed on the flexible display 240, for example, in a chip on panel (COP) manner or a chip on film (COF) manner.

According to an embodiment, the extension 2402 may extend from the flexible display 240. The extension 2402 may include electrical paths (e.g., wiring lines implemented by a conductive pattern) electrically interconnecting multiple TFTs included in the flexible display 240 and the first flexible printed circuit board 2403. The extension 2402 is a portion not included in the display area and may not include pixels.

According to an embodiment, the extension 2402 may extend from a display panel included in the flexible display 240, and the display driving circuit 2401 may be disposed on the extension 2402 (e.g., the COP manner).

According to an embodiment, the extension 2402 may extend from the second area A2 of the flexible display 240. The extension 2402 may include a fourth area A4 (see FIG. 13) disposed between the second support 421 of the second frame 221 and the second area A2 of the flexible display 240. A gluing material or an adhesive material may be disposed between the fourth area A4 of the extension 2402 (see FIG. 13) and the second area A2 of the flexible display 240. The extension 2402 may include a bent area B (see FIG. 13) bent and extending from the second area A2 to the fourth area A4 (see FIG. 13) of the flexible display 240. The display driving circuit 2401 may be disposed in the fourth area A4 (see FIG. 13) of the extension 2402. In an embodiment, the display driving circuit 2401 may be disposed in the fourth area A4 (see FIG. 13) of the extension 2402 through tape automated bonding (TAB).

According to an embodiment, one end of the first flexible printed circuit board 2403 may be electrically connected to the extension 2402. The extension 2402 and the first flexible printed circuit board 2403 may be connected through, for example, anisotropic conductive film (ACF) bonding. The ACF may be an anisotropic conductive film obtained by mixing fine conductive particles (e.g., Ni, carbon, or solder balls) with a gluing resin (or adhesive resin) (e.g., a thermosetting resin) and making the mixture into a film state such that electricity is conducted in only one direction. When the ACF is placed between the extension 2402 and the first flexible printed circuit board 2403 and then pressed by applying heat and pressure, the conductive pattern (not illustrated) provided (or configured) on the extension 2402 may be electrically connected to a conductive pattern configured (or provided) on the first flexible printed circuit board 2403 via the conductive particles, and the gluing resin (or adhesive resin) may bond the extension 2402 and the first flexible printed circuit board 2403. The other end of the first flexible printed circuit board 2403 may include a connector 2403a (e.g., an FPCB connector). The first flexible printed circuit board 2403 may pass through an opening (not illustrated) provided in the second support 221 of the second frame 221. The connector 2403a of the first flexible printed circuit board 2403 may be electrically connected to the second printed circuit board 452 disposed in the fourth support area 421B (see FIG. 13) of the second support 221. The flexible display 240 may be electrically connected to the first printed circuit board 451 disposed on the first frame 211 via the extension 2402, the first flexible printed circuit board 2403, and the second flexible printed circuit board 471. A signal commanded from a processor (e.g., the processor 120 of FIG. 1) disposed on the first printed circuit board 451 may be transferred to the display driving circuit 2401 via the first flexible printed circuit board 2403.

According to various embodiments, the extension 2402 may be a separate flexible film substrate that electrically interconnects the display panel included in the flexible display 240 and the first flexible printed circuit board 2403 (e.g., the COF manner).

According to various embodiments, the display driving circuit 2401 may be disposed on the first flexible printed circuit board 2403.

According to various embodiments, a touch sensor integrated circuit (IC) (not illustrated) electrically connected to a touch-sensitive circuit included in the flexible display 240 may be further disposed on the first flexible printed circuit board 2403. For example, the display driving circuit 2401 may include a touch display driver IC (TDDI).

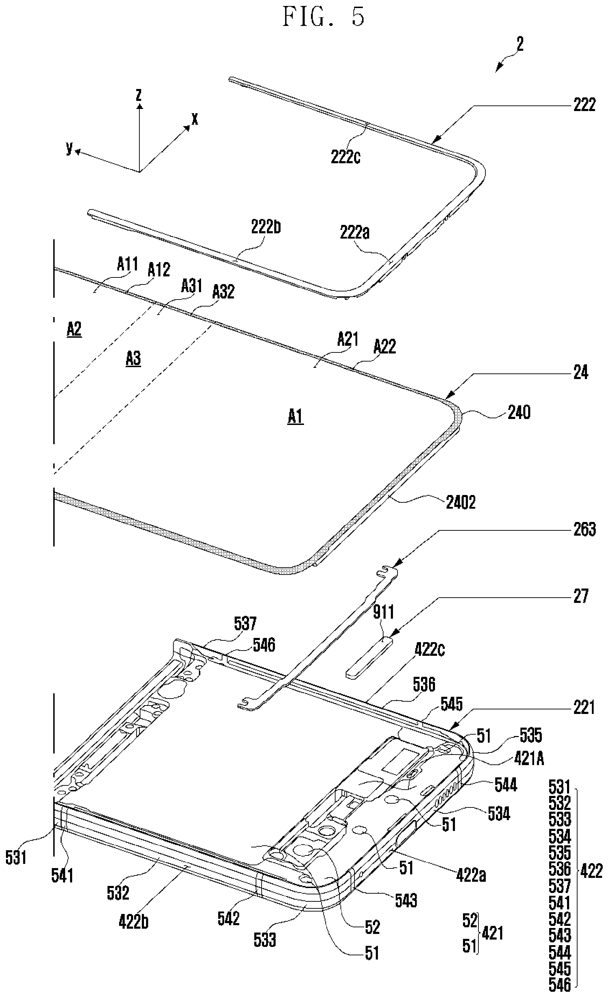

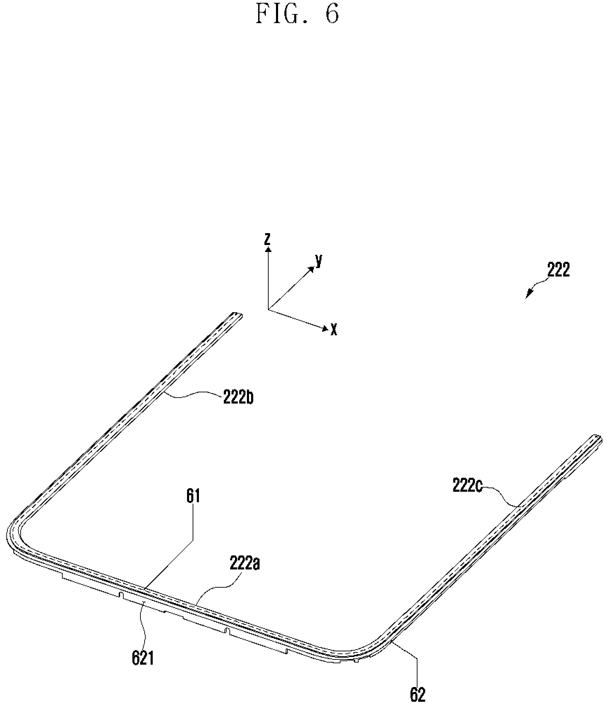

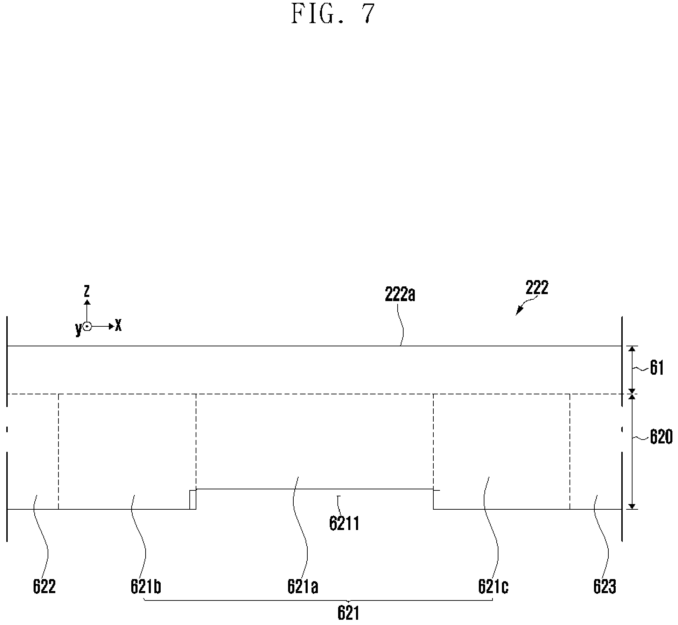

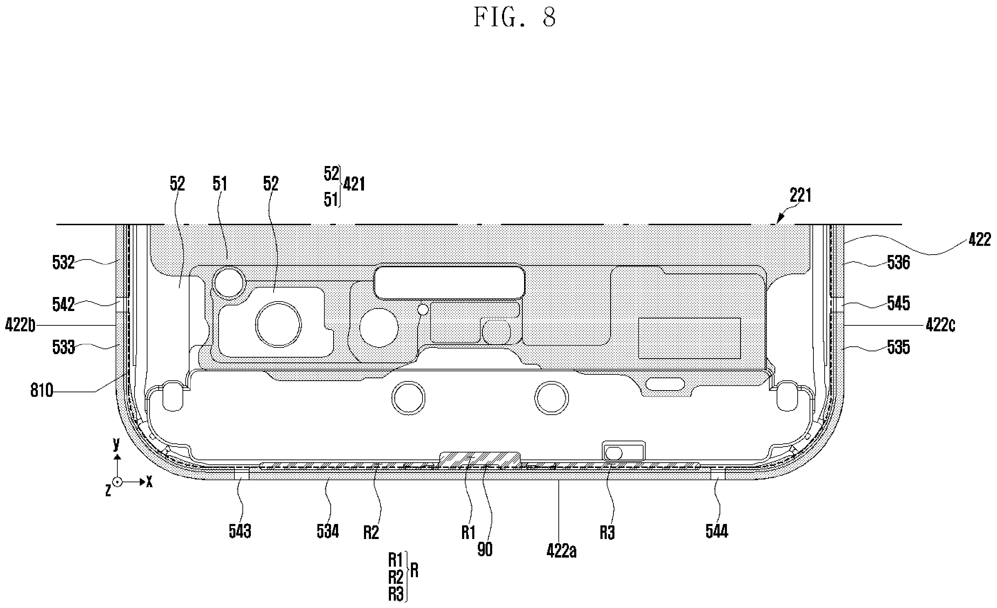

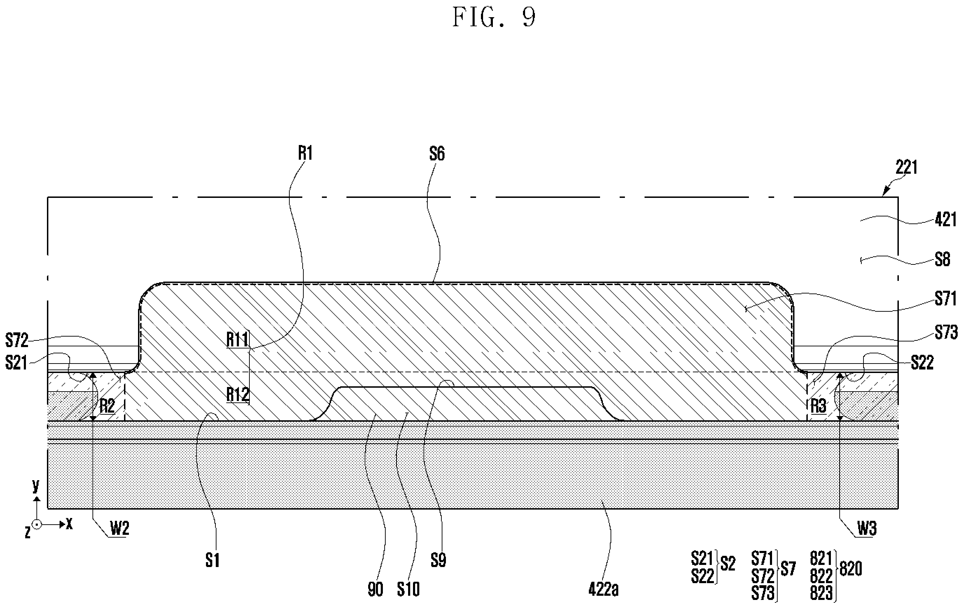

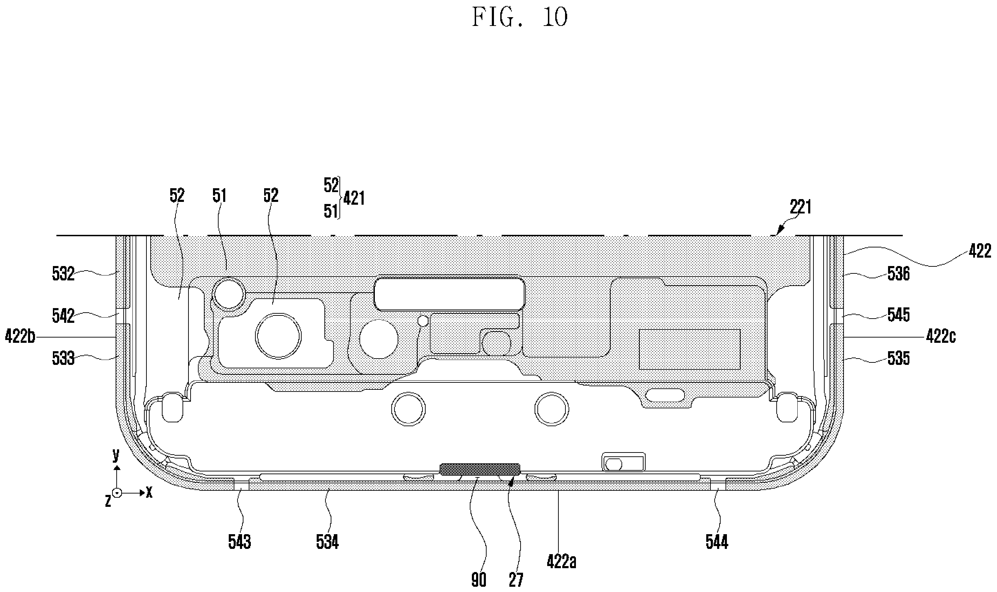

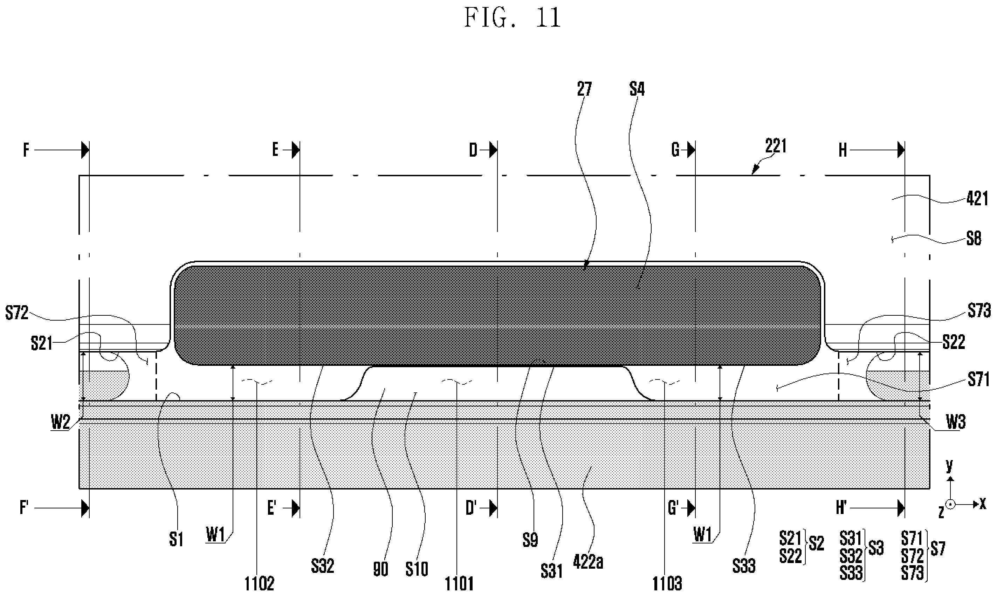

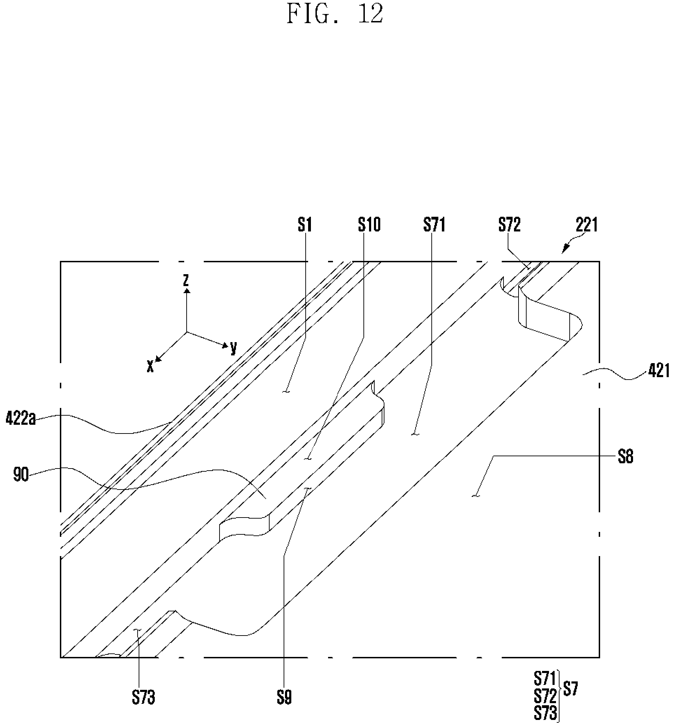

FIG. 5 is an exploded perspective view illustrating a portion of a foldable electronic device 2 according to an embodiment of the disclosure in the unfolded state. FIG. 6 is a perspective view of a fourth frame 222 according to an embodiment of the disclosure. FIG. 7 is a view illustrating a portion of a fourth frame 222 according to an embodiment of the disclosure. FIGS. 8 and 9 are views illustrating a second frame 221 according to an embodiment of the disclosure. FIGS. 10 and 11 are views illustrating a second frame 221 and a support piece 27 according to an embodiment of the disclosure. FIG. 12 is a perspective view illustrating a portion of the second frame 221 according to an embodiment of the disclosure. The coordinate axes illustrated in FIGS. 5, 6, 7, 8, 9, 10, 11, and 12 are based on the foldable electronic device 2 in the unfolded state.

Referring to FIGS. 5, 6, 7, 8, 9, 10, 11, and 12, a foldable electronic device 2 may include a second frame 221, a fourth frame 222, a first display module 24, a third gluing member (or a third adhesive member) 263, and/or a support piece 27.

According to an embodiment, the second frame 221 may include a second support 421 and a second side surface area 422.

According to an embodiment, the second support 421 may include a conductive area (or a conductive portion) 51 and a non-conductive area (or a non-conductive portion) 52 coupled to the conductive area 51. The second support 421 may provide a second support area 421A supporting a second area A2 of a first display module 24.

According to an embodiment, the second side surface area 422 may include a first conductive portion 531, a second conductive portion 532, a third conductive portion 533, a fourth conductive portion 534, a fifth conductive portion 535, a sixth conductive portion 536, a seventh conductive portion 537, a first insulating portion 541, a second insulating portion 542, a third insulating portion 543, a fourth insulating portion 544, a fifth insulating portion 545, and/or a sixth insulating portion 546. The first conductive portion 531 may provide a portion of a fifth partial side surface area 422b. The second conductive portion 532 may provide a portion of the fifth partial side surface area 422b. The third conductive portion 533 may provide a third corner where a fourth partial side surface area 422a and a fifth partial side surface area 422b are connected, a portion of the fourth partial side surface area 422a extending from the third corner, and a portion of the fifth partial side surface area 422b extending from the third corner. The fourth conductive portion 534 may provide a portion of the fourth partial side surface area 422a. The fifth conductive portion 535 may provide a fourth corner where the fourth partial side surface area 422a and a sixth partial side surface area 422c are connected, a portion of the fourth partial side surface area 422a extending from the fourth corner, and a portion of the sixth partial side surface area 422c extending from the fourth corner. The sixth conductive portion 536 may provide a portion of the sixth partial side surface area 422c. The seventh conductive portion 537 may provide a portion of the sixth partial side surface area 422c. The second side surface area 422 may include a first split portion between the first conductive portion 531 and the second conductive portion 532, and the first insulating portion 541 may be disposed in the first split portion. The second side surface area 422 may include a second split portion between the second conductive portion 532 and the third conductive portion 533, and the second insulating portion 542 may be disposed in the second split portion. The second side surface area 422 may include a third split portion between the third conductive portion 533 and the fourth conductive portion 534, and the third insulating portion 543 may be disposed in the third split portion. The second side surface area 422 may include a fourth split portion between the fourth conductive portion 534 and the fifth conductive portion 535, and the fourth insulating portion 544 may be disposed in the fourth split portion. The second side surface area 422 may include a fifth split portion between the fifth conductive portion 535 and the sixth conductive portion 536, and the fifth insulating portion 545 may be disposed in the fifth split portion. The second side surface area 422 may include a sixth split portion between the sixth conductive portion 536 and the seventh conductive portion 537, and the sixth insulating portion 546 may be disposed in the sixth split portion. The first insulating portion 541, the second insulating portion 542, the third insulating portion 543, the fourth insulating portion 544, the fifth insulating portion 545, and the sixth insulating portion 546 may provide the exterior (e.g., a side surface) of the foldable electronic device 2 together with the first conductive portion 531, the second conductive portion 532, the third conductive portion 533, the fourth conductive portion 534, the fifth conductive portion 535, the sixth conductive portion 536, and the seventh conductive portion 536. In various embodiments, the number, locations, or shapes of multiple conductive portions included in the second side surface area 422 of the second frame 221 and multiple insulating portions provided to correspond to the multiple conductive portions may vary without being limited to the illustrated example.

According to an embodiment, the first conductive portion 531, the second conductive portion 532, the third conductive portion 533, the fourth conductive portion 534, the fifth conductive portion 535, the sixth conductive portion 536, and/or the seventh conductive portion 537 may be connected to the conductive area 51 included in the second support 421 of the second frame 221. The first conductive portion 531, the second conductive portion 532, the third conductive portion 533, the fourth conductive portion 534, the fifth conductive portion 535, the sixth conductive portion 536, and/or the seventh conductive portion 537 may include the same metal material as the conductive area 51 included in the second support 421 of the second frame 221. The second frame 221 may include an integrated conductive structure (or a metal structure) including, for example, the first conductive portion 531, the second conductive portion 532, the third conductive portion 533, the fourth conductive portion 534, the fifth conductive portion 535, the sixth conductive portion 536, the seventh conductive portion 537, and the conductive area 51 of the second support 421.

According to an embodiment, the first insulating portion 541, the second insulating portion 542, the third insulating portion 543, the fourth insulating portion 544, the fifth insulating portion 545, and/or the sixth insulating portion 546 may be connected to the non-conductive area 52 included in the second support 421 of the second frame 221. The first insulating portion 541, the second insulating portion 542, the third insulating portion 543, the fourth insulating portion 544, the fifth insulating portion 545, and/or the sixth insulating portion 546 may include, for example, the same non-metal material (e.g., polymer) as the non-conductive area 52 included in the second support 421.

According to an embodiment, the first frame 211 (see FIG. 4) may be implemented to be substantially the same as or similar to the second frame 221. Although not illustrated separately, the first support 411 of the first frame 211 may include a conductive area and a non-conductive area connected to the conductive area. Although not illustrated separately, the first side surface area 412 (see FIG. 4) of the first frame 211 may include a conductive portion aligned with the first conductive portion 431 of the second side surface area 422, a conductive portion aligned with the second conductive portion 432 of the second side surface area 422, a conductive portion aligned with the third conductive portion 433 of the second side surface area 422, a conductive portion aligned with the fourth conductive portion 434 of the second side surface area 422, a conductive portion aligned with the fifth conductive portion 435 of the second side surface area 422, a conductive portion aligned with the sixth conductive portion 436 of the second side surface area 422, and/or a conductive portion aligned with the seventh conductive portion 437 of the second side surface area 422 in the state in which the foldable electronic device 2 is folded. The first side surface area 412 (see FIG. 4) of the first frame 211 may include an insulating portion aligned with the first insulating portion 541 of the second side surface area 422, an insulating portion aligned with the second insulating portion 542 of the second side surface area 422, an insulating portion aligned with the third insulating portion 543 of the second side surface area 422, an insulating portion aligned with the fourth insulating portion 544 of the second side surface area 422, an insulating portion aligned with the fifth insulating portion 545 of the second side surface area 422, and/or an insulating portion aligned with the sixth insulating portion 546 of the second side surface area 422 in the state in which the foldable electronic device 2 is folded.

According to an embodiment, at least one conductive portion (e.g., the first conductive portion 531, the second conductive portion 532, the third conductive portion 533, the fourth conductive portion 534, the fifth conductive portion 535, or the sixth conductive portion 536) included in the second side surface area 422 of the second frame 221 may be electrically connected to a wireless communication circuit (e.g., the wireless communication module 192 in FIG. 1) and may operate as an antenna radiator. At least one conductive portion included in the first side surface area 412 (see FIG. 4) of the first frame 211 may be electrically connected to a wireless communication circuit (e.g., the wireless communication module 192 of FIG. 1) and may operate as an antenna radiator.

According to an embodiment, when the at least one conductive portion included in the second side surface area 422 of the second frame 221 is used as an antenna radiator, the fourth frame 222 may be made of a non-conductive material in order to suppress degradation of radiation performance of the antenna radiator. When the at least one conductive portion included in the first side surface area 412 (see FIG. 4) of the first frame 211 is used as an antenna radiator, the third frame 212 (see FIG. 4) may be made of a non-conductive material in order to suppress degradation of radiation performance of the antenna radiator.

According to various embodiments, the third frame 212 (see FIG. 4) or the fourth frame 222 may include a conductive material and may be implemented as at least a portion of an antenna radiator.

According to an embodiment, the first display module 24 includes a flexible display 240 and an extension 2402. The flexible display 240 may include a first area A1, a second area A2, and a third area A3. The first area A1 may include a first display area A11 and a first border area A12. The second area A2 may include a second display area A21 and a second border area A22. The third area A3 may include a third display area A31 and a third border area A32.

According to an embodiment, the extension 2402 may extend from a side of the second area A2 of the flexible display 240 corresponding to the fourth partial side surface area 422a of the second frame 221. The extension 2402 may include a fourth area A4 (see FIG. 13) disposed between the second support 421 of the second frame 221 and the second area A2 of the flexible display 240. The extension 2402 may include a bent area B (see FIG. 13) that is bent and extends from the flexible display 240 to the fourth area A4 (see FIG. 13).

According to an embodiment, the first display module 24 may include a first flexible printed circuit board 2403 (see FIG. 4) electrically connected to the extension 2402. A fifth area A5 (see FIG. 13) of the first flexible printed circuit board 2403 may be electrically connected to the fourth area A4 (see FIG. 13) of the extension 2402 and may be disposed between the second area A2 of the flexible display 240 and the second support 421 of the second frame 221.

According to an embodiment, the third gluing member 263 may be at least partially disposed between the fifth area A5 (see FIG. 13) of the first flexible printed circuit board 2403 and the second support 421 of the second frame 221.

According to an embodiment, the fourth frame 222 may be coupled with the second frame 221. The second area A2 of the flexible display 240 may be disposed on the second support 421 of the second frame 221, and the fourth frame 222 may cover the second border area A22 included in the second area A2 of the flexible display 240.

According to an embodiment, the fourth frame 222 may include a fourth frame area 222a corresponding to the fourth partial side surface area 422a of the second frame 221, a fifth frame area 222b corresponding to the fifth partial side surface area 422b of the second frame 221, and a sixth frame area 222c corresponding to the sixth partial side surface area 422c of the second frame 221.

According to an embodiment, the fourth frame 222 includes a first portion 61 and a second portion 62 extending from the first portion 61. The first portion 61 covers the second border area A22 included in the second area A2 of the flexible display 240. The combination of the first portion 61 of the fourth frame 222 and the second side surface area 422 of the second frame 221 may provide a second bezel B2 (see FIG. 2) surrounding the second display area A21 when viewed from above the second display area A21 of the flexible display 240. The second portion 62 of the fourth frame 222 may be located in the inner space of the foldable electronic device 2 and may not be exposed to the outside. The second portion 62 may be coupled (or fixed) to the second frame 221. Thereby, the second portion 62 of the fourth frame 222 may prevent the positional deviation of the fourth frame 222 and the support piece 27 in case of the external impact applied to the flexible display 240. The first portion 61 may be supported by the second portion 62 coupled to the second frame 221 and disposed at a predetermined position with respect to the second frame 221. The first portion 61 and the second portion 62 of the fourth frame 222 may support the flexible display 240 and alleviate an external impact applied to the flexible display 240.

According to an embodiment, the first portion 61 of the fourth frame 222 may have a form in which a portion included in the fourth frame area 222a of the fourth frame 222, a portion included in the fifth frame area 222b of the fourth frame 222, and a portion included in the sixth frame area 222c of the fourth frame 222 are connected to each other.

According to an embodiment, the second portion 62 of the fourth frame 222 may include a portion (e.g., a first rib 620) included in the fourth frame area 222a of the fourth frame 222, a portion (e.g., a second rib) included in the fifth frame area 222b of the fourth frame 222, and a portion (e.g., a third rib) included in the sixth frame area 222c of the fourth frame 222.

According to an embodiment, although not illustrated separately, the third frame 212 disposed on the first frame 211 (see FIG. 4) may be provided to be at least partially the same as or similar to the fourth frame 222 disposed on the second frame 221.

According to an embodiment, the second frame 221 (or the second support 421) may include at least one recess into which the second portion 62 of the fourth frame 222 is inserted. The at least one recess may be a cut groove provided in the second frame 221 so that the second portion 62 of the fourth frame 222 is insertable. The at least one recess may be at least partially provided in, for example, an area adjacent to and along the second side surface area 422 of the second frame 221 (e.g., the area extending along the dotted line indicated by reference numeral "810"). The at least one recess may be provided in the second support 421 to be adjacent to, for example, a portion where the second support 421 and the second side surface area 422 are connected.

According to an embodiment, the second frame 221 may include a recess R into which the first rib 620 of the second portion 62 of the fourth frame 222 included in the fourth frame area 222a is inserted. The recess R may include a first recess area R1, a second recess area R2, and/or a third recess area R3. When viewed from above the second display area A21 of the flexible display 240, the first recess area R1, the second recess area R2, and the third recess area R3 may be disposed in the direction of the center line C of the foldable electronic device 2 (e.g., the x-axis direction), and the first recess area R1 may be located between the second recess area R2 and the third recess area R3.

According to an embodiment, the second frame 221 may not include a partition wall between the first recess area R1 and the second recess area R2, and the space of the first recess area R1 and the space of the second recess area R2 may be connected. In various embodiments, the second frame 221 may include a first partition wall (not illustrated separately) between the first recess area R1 and the second recess area R2, and the space of the first recess area R1 and the second recess area R2 may be separated. For example, the first rib 620 of the fourth frame 222 may include a groove (or a notch) corresponding to the first partition wall.

According to an embodiment, the second frame 221 may not include a partition wall between the first recess area R1 and the third recess area R3, and the space of the first recess area R1 and the space of the third recess area R3 may be connected. In various embodiments, the second frame 221 may include a second partition wall (not illustrated separately) between the first recess area R1 and the third recess area R3, and the space of the first recess area R1 and the third recess area R3 may be separated. For example, the first rib 620 of the fourth frame 222 may include a groove (or a notch) corresponding to the second partition wall.

According to an embodiment, the recess R may provide a recessed space with a combination of multiple surfaces. The recess R may include, for example, a first surface S1, a second surface S2, a sixth surface S6, and/or a seventh surface S7. The seventh surface S7 may be the bottom surface of the recess R. The first surface S1, the second surface S2, and the sixth surface S6 may be side surfaces of the recess R. When viewed from above the second display area A21 of the flexible display 240, the shape of the recess R may be provided by the combination of the first surface S1, the second surface S2 spaced apart from the first surface S1 on the opposite side to the first surface S1, and the sixth surface S6 spaced apart from the first surface S1 on the opposite side to the first surface S1.

According to an embodiment, the first surface S1 of the recess R may be provided by the fourth partial side surface area 422a included in the fourth side surface area 422 of the second frame 221. In various embodiments, the first surface S1 may be provided by the second support 421 of the second frame 221.

According to an embodiment, the first surface S1 may include a partial area included in the first recess area R1, a partial area included in the second recess area R2, and a partial area included in the third recess area R3. When viewed from above the second display area A21 of the flexible display 240, the partial area of the first surface S1 included in the first recess area R1, the partial area of the first surface S1 included in the second recess area R2, and the partial area of the first surface S1 included in the third recess area R3 may be provided without a in the direction in which in a direction perpendicular to the center line C (see FIG. 2) of the foldable electronic device 2 (e.g., the y-axis direction).

According to various embodiments, when viewed from above the second display area A21 of the flexible display 240, the partial area of the first surface S1 included in the first recess area R1 and the partial area of the first surface S1 included in the second recess area R2 may be provided at different heights in a direction perpendicular to the center line C (see FIG. 2) of the foldable electronic device 2 (e.g., the y-axis direction). In various embodiments, when viewed from above the second display area A21 of the flexible display 240, the partial area of the first surface S1 included in the first recess area R1 and the partial area of the first surface S1 included in the third recess area R3 may be provided at different heights in a direction perpendicular to the center line C (see FIG. 2) of the foldable electronic device 2 (e.g., the y-axis direction).

According to an embodiment, the second surface S2 of the recess R may be spaced apart from the first surface S1 in a direction perpendicular to the center line C (see FIG. 2) of the foldable electronic device 2 (e.g., the y-axis direction) when viewed from above the second display area A21 of the flexible display 240. The first surface S1 and the second surface S2 may face each other. The second surface S2 may include a partial area S21 included in the second recess area R2 and a partial area S22 included in the third recess area R3. The partial area S21 of the second surface S2 included in the second recess area R2 may be spaced apart from the first surface S1 by a second distance W2 in a direction perpendicular to the center line C (see FIG. 2) of the foldable electronic device 2 (e.g., the y-axis direction) when viewed from above the second display area A21 of the flexible display 240. The partial area S22 of the second surface S2 included in the third recess area R3 may be spaced apart from the first surface S1 by a third distance W3 in a direction perpendicular to the center line C (see FIG. 2) of the foldable electronic device 2 (e.g., the y-axis direction) when viewed from above the second display area A21 of the flexible display 240. The second distance W2 may be interpreted as the width of the second recess area R2. The third distance W3 may be interpreted as the width of the third recess area R3. In an embodiment, the second distance W2 and the third distance W3 may be substantially equal. In various embodiments, the second distance W2 and the third distance W3 may be different (not illustrated separately).

According to an embodiment, the sixth surface S6 of the recess R may be included in the first recess area R1. The sixth surface S6 may interconnect the partial area S21 of the second surface S2 included in the second recess area R2 and the partial area S22 of the second surface S2 included in the third recess area R3. When viewed from above the second display area A21 of the flexible display 240, the first recess area R1 may further include an area (hereinafter, referred to as an "extension area") R11 extending in a protruding form with respect to the second surface S2 compared with the second recess area R2 and the third recess area R3. For example, the first recess area R1 may include, for example, a central area R12 between the second recess area R2 and the third recess area R3 and an extension area R11 extending from the central area R12 when viewed from above the second display area A21 of the flexible display 240. The extension area R11 may include the sixth surface S6. The extension area R11 may not be limited to the illustrated example and may be provided in various ways.

According to an embodiment, the seventh surface S7 of the recess R may be substantially oriented in the direction in which the second front surface (or the second front surface area) provided by the second display area 21 among the outer surfaces of the foldable electronic device 2 is oriented. The seventh surface S7 may include a partial area S71 included in the first recess area R1, a partial area S72 included in the second recess area R2, and a partial area S73 included in the third recess area R3. The depth of the first recess area R1 may be interpreted as a height difference between the partial area S71 of the seventh surface S7 included in the first recess area R1 and a peripheral area (hereinafter, referred to as an "eighth surface S8") of the second support 421 adjacent to the recess R. The depth of the second recess area R2 may be interpreted as a height difference between the partial area S72 of the seventh surface S7 included in the second recess area R2 and the eighth surface S8. The depth of the third recess area R3 may be interpreted as a height difference between the partial area S73 of the seventh surface S7 included in the third recess area R3 and the eighth surface S8.

According to an embodiment, the partial area S71 of the seventh surface S7 included in the first recess area R1, the partial area S72 of the seventh surface S7 included in the second recess area R2, and the partial area S73 of the seventh surface S7 included in the third recess area R3 may be provided without a substantial difference in the direction in which the second front surface (or the second front surface area) provided by the second display area A21 among the outer surfaces of the foldable electronic device 2 is oriented.

According to various embodiments, the partial area S71 of the seventh surface S7 included in the first recess area R1 and the partial area S72 of the seventh surface S7 included in the second recess area R2 may be provided at different heights in the direction in which the second front surface (or the second front surface area) provided by the second display area A21 among the outer surfaces of the foldable electronic device 2 is oriented.

According to various embodiments, the partial area S71 of the seventh surface S7 included in the first recess area R1 and the partial area S73 of the seventh surface S7 included in the second recess area R3 may be provided at different heights in the direction in which the second front surface (or the second front surface area) provided by the second display area A21 among the outer surfaces of the foldable electronic device 2 is oriented.

According to an embodiment, the support piece 27 may be disposed in the first recess area R1 of the recess R. The support piece 27 may be, for example, substantially cuboid.

According to an embodiment, when viewed from above the second display area A21 of the flexible display 240, a portion of the support piece 27 may be located in the extension area R11 of the first recess area R1 and the remaining portion of the support piece 27 may be located in the central area R12 of the first recess area R1. When viewed from above the second display area A21 of the flexible display 240, the sixth surface S6 of the recess R may extend along the border of the portion of the support piece 27 located in the extension area R11 of the first recess area R1. In an embodiment, the portion of the support piece 27 located in the extension area R11 of the first recess area R1 may be fitted into a space provided by the combination of the sixth face S6 and the seventh face S7.

According to an embodiment, the second frame 221 may include a protrusion 90 extending from the first surface S1 or the fourth partial side surface area 422a of the second frame 221. The protrusion 90 of the second frame 221 may support the support piece 27 not to move toward the first surface S1. When viewed from above the second display area A21 of the flexible display 240, the protrusion 90 may be located between the support piece 27 and the first surface S1 of the recess R. The protrusion 90 may support the support piece 27 such that a separation distance between the support piece 27 and the first surface S1 may be maintained. The combination of the sixth face S6, the seventh face S7, and the protrusion 90 may provide a fit structure that supports the support piece 27 to be stably located in the first recess area R1. In various embodiments, surfaces provided by the protrusion 90 may be interpreted as some of multiple surfaces included in the first recess area R1.

According to an embodiment, the protrusion 90 may include a ninth surface S9 and a tenth surface S10. The ninth surface S9 may be a surface capable of supporting the support piece 27 of the protrusion 90. The tenth surface S10 may be substantially oriented in the direction in which the second front surface (or the second front surface area) provided by the second display area A21 among the outer surfaces of the foldable electronic device 2 is oriented. The tenth surface S10 may be located to be higher than the seventh surface S7 in the direction in which the second front surface (or the second front surface area) provided by the second display area A21 among the outer surfaces of the foldable electronic device 2 is oriented.

According to an embodiment, the tenth surface S10 of the protrusion 90 may be located to be lower than the eighth surface S8 of the second frame 221 in the direction in which the second front surface (or the second front surface area) provided by the second display area 21 among the outer surfaces of the foldable electronic device 2 is oriented.

According to various embodiments, the tenth surface S10 of the protrusion 90 may be provided without a substantial difference in height from the eighth surface S8 of the second frame 221 in the direction in which the second front surface (or the second front surface area) provided by the second display area 21 among the outer surfaces of the foldable electronic device 2 is oriented.

According to various embodiments, the tenth surface S10 of the protrusion 90 may be located to be higher than the eighth surface S8 of the second frame 221 in the direction in which the second front surface (or the second front surface area) provided by the second display area 21 among the outer surfaces of the foldable electronic device 2 is oriented.

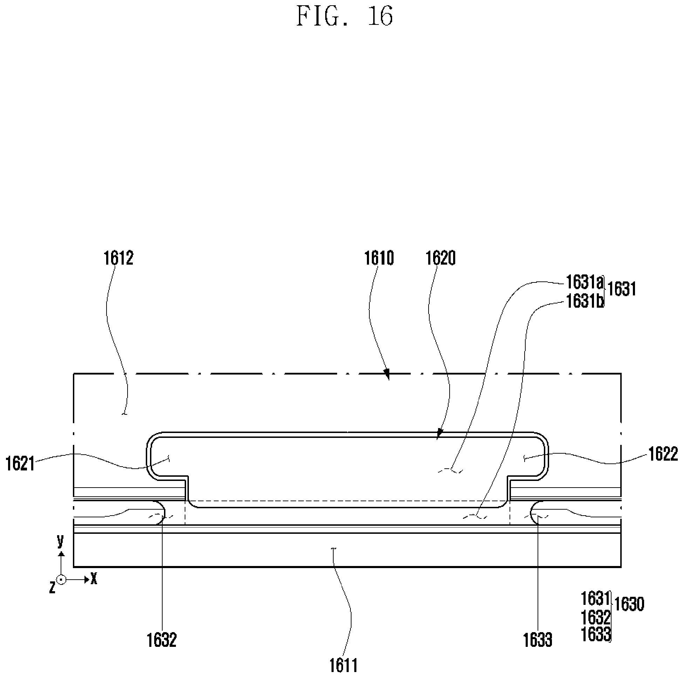

According to various embodiments, the extension area R11 of the first recess area R1 and the portion of the support piece 27 disposed in the extension area R11 may be implemented such that the support piece 27 does not deviate toward the first surface S1 even without the protrusion 90. This will be described later with reference to FIGS. 16, 17, 18, 19, and 20.

According to an embodiment, the support piece 27 may include a third surface S3, a fourth surface S4, and a fifth surface S5 (see FIG. 13). The third surface S3 may face the first surface S1 of the recess R. The third surface S3 may be a surface supported by the protrusion 90 of the support piece 27. The third surface S3 may face the ninth surface S9 of the protrusion 90. The third surface S3 may be included in a portion of the support piece 27 located in the central area R12 of the first recess area R1. The fourth surface S4 may be substantially oriented in the direction in which the second front surface (or the second front surface area) provided by the second display area A21 among the outer surfaces of the foldable electronic device 2 is oriented. The fifth surface S5 (see FIG. 13) may face the seventh surface S7.

According to an embodiment, the fourth surface S4 of the support piece 27 may be located to be higher than the tenth surface S10 of the protrusion 90 in the direction in which the second front surface (or the second front surface area) provided by the second display area 21 among the outer surfaces of the foldable electronic device 2 is oriented.

According to various embodiments, the fourth surface S4 of the support piece 27 may be located without a substantial difference in height from the tenth surface S10 of the protrusion 90 in the direction in which the second front surface (or the second front surface area) provided by the second display area 21 among the outer surfaces of the foldable electronic device 2 is oriented.

According to various embodiments, the fourth surface S4 of the support piece 27 may be located to be lower than the tenth surface S10 of the protrusion 90 in the direction in which the second front surface (or the second front surface area) provided by the second display area 21 among the outer surfaces of the foldable electronic device 2 is oriented.

According to an embodiment, the support piece 27 may be coupled with the second support 421 of the frame 221. The support piece 27 may be coupled with the seventh surface S7 of the recess R via, for example, the first gluing member (or the first adhesive member) 261 (see FIG. 13) disposed between the fifth surface S5 (see FIG. 13) of the support piece 27 and the seventh surface S7 of the recess R.

According to various embodiments, the support piece 27 may be coupled with the second support 421 of the frame 221 through screw fastening (not illustrated separately). For example, the protrusion 90 may be omitted.

According to an embodiment, when viewed from above the second display area A21 of the flexible display 240, in the direction of the center line C (see FIG. 2) of the foldable electronic device 2 (e.g., the x-axis direction), the distance by which the support piece 27 is spaced apart from the fifth partial side surface area 422b of the second side surface area 422 and the distance by which the support piece 27 is spaced apart from the sixth partial side surface area 422c of the second side surface area 422 may be substantially equal to each other.

According to an embodiment, the first rib 620 may include a first rib area 621, a second rib area 622, and/or a third rib area 623. The first rib area 621 may be a portion interconnecting the second rib area 622 and the third rib area 623 of the first rib 620. The first rib area 621 may be inserted into the first recess area R1. The second rib area 622 may be inserted into the second recess area R2. The third rib area 623 may be inserted into the third recess area R3.

According to an embodiment, the first rib area 621 of the first rib 620 may include a notch 6211 corresponding to the protrusion 90. The first rib area 621 may include a first partial rib area 621a, a second partial rib area 621b, and/or a third partial rib area 621c. In the direction of the center line C (see FIG. 2) of the foldable electronic device 2 (e.g., the x-axis direction), the first partial rib area 621a may be disposed between the second partial rib area 621b and the third partial rib area 621c. The first partial rib area 621a may be located to correspond to the protrusion 90. The first partial rib area 621a may extend from the first portion 61 toward the tenth surface S10 of the protrusion 90. The second partial rib area 621b may be disposed between the first partial rib area 621a and the second rib area 622. The third partial rib area 621c may be disposed between the first partial rib area 621a and the third rib area 623. The second partial rib area 621b and the third partial rib area 621c may extend toward the partial area S71 of the seventh surface S7 of the recess R included in the first recess area R1. Due to the difference in the extending lengths of the first partial rib area 621a and the second partial rib area 621b and the difference in the extending lengths of the first partial rib area 621a and the third partial rib area 621c, a notch 6211 may be provided.

According to an embodiment, the second rib area 622 of the first rib 620 may extend from the first portion 61 toward the partial area S72 of the seventh surface S7 of the recess R included in the second recess area R2.

According to an embodiment, the third rib area 623 of the first rib 620 may extend from the first portion 61 toward the partial area S73 of the seventh surface S7 of the recess R included in the third recess area R3.

According to an embodiment, the third surface S3 of the support piece 27 may include a first partial area S31, a second partial area S32, and/or a third partial area S33. When viewed from above the second display area A21 of the flexible display 240, in the direction of the center line C (see FIG. 2) of the foldable electronic device 2 (e.g., the x-axis direction), the first partial area S31 may be located between the second partial area S32 and the third partial area S33.

According to an embodiment, the first partial area S31 of the third surface S3 may face the ninth surface S9 of the protrusion 90. The protrusion 90 may support the first partial area S31 of the third surface S3 such that the support piece 27 does not move toward the first surface S1.

According to an embodiment, the second partial area S32 of the third surface S3 may be located between the first partial area S31 and the second recess area R2 when viewed from above the second display area A21 of the flexible display 240. The second partial area S32 may be spaced apart from the first surface S1 by a first distance W1 in a direction perpendicular to the center line C (see FIG. 2) of the foldable electronic device 2 (e.g., the y-axis direction) when viewed from above the second display area A21 of the flexible display 240. The partial area S21 of the second surface S2 included in the second recess area R2 may be spaced apart from the first surface S1 by a second distance W2 in a direction perpendicular to the center line C (see FIG. 2) of the foldable electronic device 2 (e.g., the y-axis direction) when viewed from above the second display area A21 of the flexible display 240. In an embodiment, the first distance W1 may be smaller than the second distance W2.

According to an embodiment, the third partial area S33 of the third surface S3 may be located between the first partial area S31 and the third recess area R3 when viewed from above the second display area A21 of the flexible display 240. The third partial area S33 may be spaced apart from the first surface S1 by the first distance W1 in a direction perpendicular to the center line C (see FIG. 2) of the foldable electronic device 2 (e.g., the y-axis direction) when viewed from above the second display area A21 of the flexible display 240. The partial area S22 of the second surface S2 included in the third recess area R3 may be spaced apart from the first surface S1 by a third distance W3 in a direction perpendicular to the center line C (see FIG. 2) of the foldable electronic device 2 (e.g., the y-axis direction) when viewed from above the second display area A21 of the flexible display 240. In an embodiment, the first distance W1 may be smaller than the third distance W3.

According to an embodiment, the first partial area S31, the second partial area S32, and the third partial area S3 of the third surface S3 may be provided without a substantial difference in height in a direction perpendicular to the center line C (see FIG. 2) of the foldable electronic device 2 (e.g., the y-axis direction). The third surface S3 may be, for example, a flat surface substantially parallel to the first surface S1.

According to various embodiments, the support piece 27 may be implemented in a modified form such that the first partial area S31 and the second partial area S32 of the third surface S3 are provided at different heights in a direction perpendicular to the center line C (see FIG. 2) of the foldable electronic device 2 (e.g., the y-axis direction) while making the first distance W1 smaller than the second distance W2.

According to various embodiments, the support piece 27 may be implemented in a modified form such that the first partial area S31 and the third partial area S33 of the third surface S3 are provided at different heights in a direction perpendicular to the center line C (see FIG. 2) of the foldable electronic device 2 (e.g., the y-axis direction) while making the first distance W1 smaller than the third distance W3.

According to an embodiment, the second partial rib area 621b included in the first rib area 621 of the first rib 620 may be inserted into a space 1102 of the recess R between the second partial area S32 of the third surface S3 and the first surface S1. The third partial rib area 621c included in the first rib area 621 of the first rib 620 may be inserted into a space 1103 of the recess R between the third partial area S33 of the third surface S3 and the first surface S1.

According to an embodiment, the space 1102 of the recess R between the second partial area S32 of the third surface S3 and the first surface S1 and the space 1103 of the recess R between the third partial area S33 of the third surface S3 and the first surface S1 may guide a position where the first rib 620 is disposed with respect to the second frame 221 or the first display module 24 in the operation of arranging the fourth frame 222 on the second frame 221.

According to an embodiment, the fourth surface S4 of the support piece 27 may be located to be higher than the tenth surface S10 of the protrusion 90 in the direction in which the second front surface (or the second front surface area) provided by the second display area 21 among the outer surfaces of the foldable electronic device 2 is oriented. For example, the first partial rib area 621a included in the first rib area 621 of the first rib 620 may be inserted into the space 1101 between the first partial area 31 included in the third surface S3 of the support piece 27 and the first surface S1 of the second frame 221. The space 1101 between the first partial area S31 included in the third surface S3 of the support piece 27 and the first surface S1 of the second frame 221 may guide a position where the first rib 620 is disposed with respect to the second frame 221 or the first display module 24 in the operation of arranging the fourth frame 222 on the second frame 221.

According to an embodiment, a method of manufacturing the second frame 221 may include insert injection molding and outer shape machining. Insert injection molding may include placing a metal element in a mold, injecting molten resin into the mold, cooling the injected molten resin, taking out a metal-non-metal structure in a form in which the metal element and a non-metal portion including the resin are coupled from the mold. The metal element included in the metal-non-metal structure may be a base of the conductive area 51 of the second frame 221. The non-metal portion included in the metal-non-metal structure may be the base of the non-conductive area 52 of the second frame 221. The outer shape machining may be cutting the metal-non-metal structure manufactured through insert injection molding for obtaining the actual outer shape of the second frame 221. The outer shape machining may include various types of cutting such as CNC. At least one recess (e.g., the recess R) of the second frame 221 into which the second portion 62 of the fourth frame 222 is inserted may be formed through outer shape machining.

During the manufacturing of the second frame 221, since it is necessary to suppress defects or damage to a cutting tool during outer surface machining, there may be a restriction on reducing the width of the at least one rib into which the second portion 62 of the fourth frame 222 is inserted is provided. In an embodiment, in a direction perpendicular to the center line C of the foldable electronic device 2 (see FIG. 2) when viewed from above the second display area A21 of the flexible display 240, the width of the second recess area R2 (e.g., the second distance W2), into which the second rib area 622 of the first rib 620 is inserted, is provided as narrow as possible in consideration of the restriction when molding the second frame 221. In an embodiment, in a direction perpendicular to the center line C of the foldable electronic device 2 (see FIG. 2) when viewed from above the second display area A21 of the flexible display 240, the width of the third recess area R3 (e.g., the third distance W3), into which the third rib area 623 of the first rib 620 is inserted, is provided as narrow as possible in consideration of the restriction when molding the second frame 221. For example, the width of the second recess area R2 and/or the width of the third recess area R3 may be about 0.6 mm, but are not limited thereto.

According to an embodiment, the restriction that makes it difficult to reduce the width of the at least one recess into which the second portion 62 of the fourth frame 222 is inserted during the manufacturing of the second frame 221 may be solved through the combination of the second frame 221 and the support piece 27. Through the combination of the second frame 221 and the support piece 27, a recessed space 1101, 1102, or 1103 into which the first rib area 621 of the first rib 620 is inserted may be provided. When the fourth frame 222 is disposed on the second frame 221, the recessed space 1101, 1102, or 1103 provided through the combination of the second frame 221 and the support piece 27 may guide the insertion of the first rib area 621 of the rib 620. In an embodiment, the width of the recessed space 1101, 1102, or 1103 provided through the combination of the second frame 221 and the support piece 27 (e.g., the first distance W1 between the first surface S1 and the third surface S3) may be smaller than the width of the second recess area R2 (e.g., the second distance W2) and the width of the third recess area R3 (e.g., the third distance W3).

According to an embodiment, the fourth frame 222 (and/or the third frame 212 of FIG. 4) may be manufactured through injection molding. The fourth frame 222 (and/or the fourth third frame 212) may be manufactured through a variety of other methods.

According to an embodiment, the first rib 620 of the fourth frame 222 may face the bent area B (FIG. 13) of the extension 2402 of the first display module 24. The separation distance between the first rib 620 of the fourth frame 222 and the bent area B (see FIG. 13) of the first display module 24 may be provided in order to suppress or prevent a collision between the first rib 620 and the bent area B (see FIG. 13) due to an external impact due to a reason such as a drop. In order to secure a separation distance between the first rib 620 of the fourth frame 222 and the bent area B (see FIG. 13) of the first display module 24, the first rib 620 may be provided to have a width as narrow as possible in a direction corresponding to the separation distance.

Since it is necessary to manufacture the fourth frame 222 to suppress molding defects or to secure rigidity (or durability), there may be a restriction on the shape (e.g., the width) of the second portion 62 of the fourth frame 222 including the first rib 620. In an embodiment, in the direction corresponding to the separation distance between the first rib 620 of the fourth frame 222 and the bent area B of the first display module 24 (see FIG. 13), the width of the first rib 620 may be provided as narrow as possible in consideration of a manufacturing restriction of the fourth frame 222. For example, the width of the first rib 620 may be about 0.4 mm, but is not limited thereto.

According to an embodiment, the first rib 620 may be provided to have a width capable of securing a separation distance from the bent area B (see FIG. 13) of the first display module 24 in consideration of a manufacturing restriction of the fourth frame 222. In an embodiment, the recessed space 1101, 1102, or 1103 provided through the combination of the second frame 221 and the support piece 27 may have a width capable of suppressing loose insertion (or loose fit) of the first rib area 621 of the first rib 620. In an embodiment, the recessed space 1101, 1102, or 1103 provided through the combination of the second frame 221 and the support piece 27 may reduce a positional deviation between the second frame 221 and the fourth frame 222.

According to an embodiment, the fourth frame 222 (and/or the third frame 212 in FIG. 4) may include a non-metal material. The fourth frame 222 (and/or the third frame 212 in FIG. 4) may include various polymers such as engineering plastics (e.g., polycarbonate (PC) or polymethyl methacrylate (PMMA)). The fourth frame 222 (and/or the third frame 212 in FIG. 4) may include a polymer resin such as polyether ether ketone, polyphenylene sulfide, polybutylene terephthalate, polyimide, or polycarbonate. In various embodiments, the fourth frame 222 (and/or the third frame 212 of FIG. 4) may include a material in which engineering plastics are mixed with various reinforcing base materials such as glass fibers or carbon fibers (e.g., fiber-reinforced plastics (FRP)).

According to various embodiments, the fourth frame 222 (and/or the third frame 212 in FIG. 4) may include a metal material. The fourth frame 222 (and/or the third frame 212 in FIG. 4) may include various metal materials such as titanium, an amorphous alloy, a metal-ceramic composite material (e.g., cermet), stainless steel, magnesium, a magnesium alloy, aluminum, an aluminum alloy, a zinc alloy, or a copper alloy.

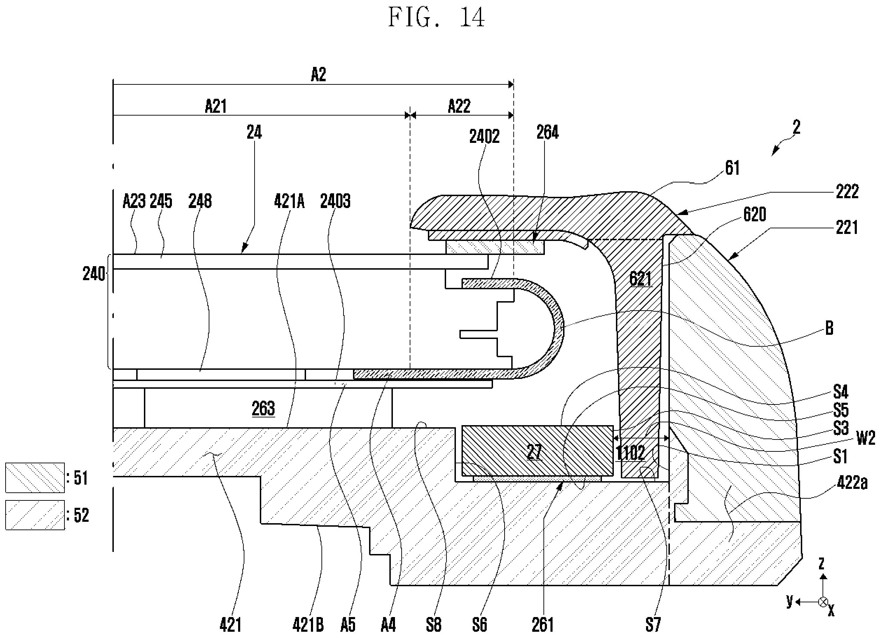

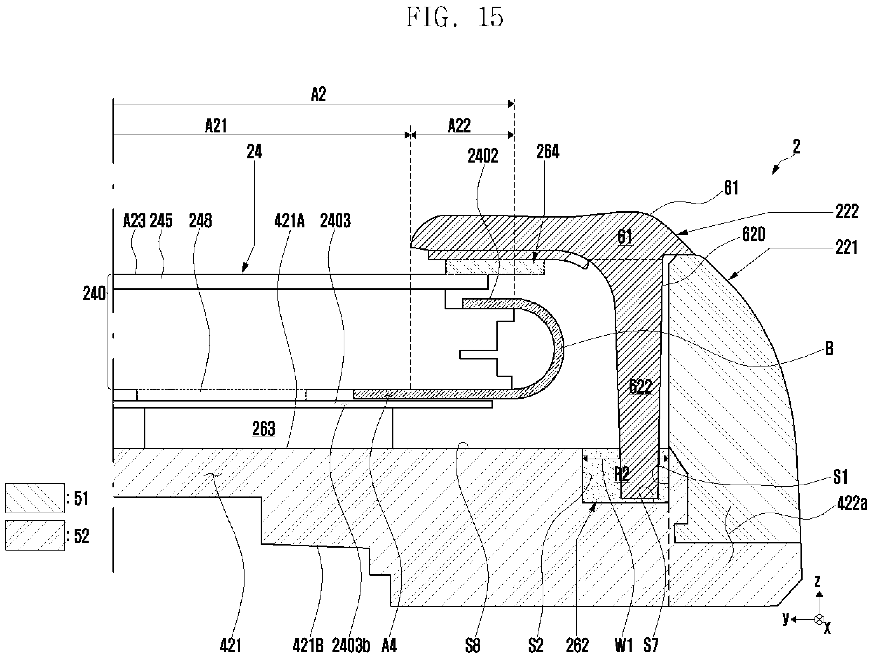

FIG. 13 is a cross-sectional view illustrating a portion of the foldable electronic device 2 according to an embodiment of the disclosure taken along line D-D' in FIG. 11. FIG. 14 is a cross-sectional view illustrating a portion of the foldable electronic device 2 according to an embodiment of the disclosure taken along line E-E' in FIG. 11. FIG. 15 is a cross-sectional view illustrating a portion of the foldable electronic device 2 according to an embodiment of the disclosure taken along line F-F' in FIG. 11. The coordinate axes illustrated in FIGS. 13, 14, and 15 are based on the foldable electronic device 2 in the unfolded state.

Referring to FIGS. 13, 14, and 15, the foldable electronic device 2 may include a second frame 221, a fourth frame 222, a first display module 24, a support piece 27, a first gluing member (or a first adhesive member) 261, a second gluing member (or a second adhesive member) 262, a third gluing member (or a third adhesive member) 263, and/or a fourth gluing member (or a fourth adhesive member) 264.

According to an embodiment, the second frame 221 may be provided through a combination of a conductive area 51 and a non-conductive area 52. The second frame 221 may include a second support 421 and a fourth partial side surface area 422a. The second support 421 may include a second support area 421A and a fourth support area 421B. The second support area 421A may face a second display area A21 of the first display module 24, and the fourth support area 421B may face a second cover 223 (see FIG. 2).

According to an embodiment, the fourth frame 222 may be disposed on or coupled with the second frame 221. The fourth frame 222 may include a first portion 61 and a first rib 620 extending from the first portion 61.

According to an embodiment, the second area A2 of the flexible display 240 may be disposed on the second support area 421A of the second support 421.

According to an embodiment, the second area A2 of the flexible display 240 may include a second display area A21 and a second border area A22. The second border area A22 may not include multiple pixels. The second border area A22 may be covered by the first portion 61 of the fourth frame 222 and may be substantially invisible with viewed from above the second display area A21. The second display area A21 may provide a portion of the front surface (e.g., the second front surface A23) of the foldable electronic device 2.

According to an embodiment, referring to a cross-sectional view 24S of the first display module 24, the first display module 24 may include a flexible display 240 and a support sheet 247.

According to an embodiment, the flexible display 240 may include a display panel 241, a base film 242, a lower panel 243, an optical layer 244, a transparent cover 245, and/or an optical transparent gluing portion (or an optical transparent adhesive portion) 246. The display panel 241 may be disposed between the base film 242 and the optical layer 244. The base film 242 may be disposed between the display panel 241 and the lower panel 243. The optical layer 244 may be disposed between the display panel 241 and the optical transparent gluing portion 246. The optical transparent gluing portion 246 may be disposed between the optical layer 244 and the transparent cover 245. The optical transparent gluing portion 246 may include, for example, an optical clear adhesive (OCA), an optical clear resin (OCR), or a super view resin (SVR). Between the display panel 241 and the base film 242, between the base film 242 and the lower panel 243, and/or between the display panel 241 and the optical layer 244, various polymer gluing materials (or gluing members) or adhesive materials (or adhesive members) may be disposed (not illustrated separately).

According to an embodiment, the display panel 241 may include a light-emitting layer 241a, a thin film transistor (TFT) film 241b, and/or an encapsulation (e.g., a thin-film encapsulation (TFE)) 241c. The light-emitting layer 241a may include, for example, multiple pixels implemented by light-emitting elements such as organic light-emitting diodes (OLEDs) or micro-LEDs. The light-emitting layer 241a may be disposed on the TFT film 241b through organic material evaporation. The TFT film 241b may be positioned between the light-emitting layer 241a and the base film 242. The TFT film 241b may refer to a film structure in which at least one TFT is disposed on a flexible substrate (e.g., a PI film) through a series of processes such as deposition, patterning, and/or etching. At least one TFT may control a current to a light-emitting element of the light-emitting layer 241a to turn on or off a pixel or to adjust brightness of a pixel. The at least one TFT may be implemented as, for example, an amorphous silicon (a-Si) TFT, a liquid crystalline polymer (LCP) TFT, a low-temperature polycrystalline oxide (LTPO) TFT, or a low-temperature polycrystalline silicon (LTPS) TFT. In an embodiment, the display panel 241 may include a storage capacitor, and the storage capacitor may maintain a voltage signal to the pixel, may maintain a voltage applied to the pixel within one frame, or may suppress a change in the gate voltage of the TFT due to leakage during a light emission time. By a routine for controlling at least one TFT (e.g., initialization or data write), the storage capacitor may maintain the voltage applied to the pixels at regular time intervals. In an embodiment, the display panel 241 may be implemented based on OLEDs, and the encapsulation 241c may cover the light-emitting layer 241a. The organic materials and electrodes that emit light in the OLEDs may react very sensitively to oxygen and/or moisture and may lose light-emitting properties thereof. In order to suppress or prevent this phenomenon, the encapsulation 241c may seal the light-emitting layer 241a to prevent oxygen and/or moisture from penetrating into the OLEDs. The encapsulation 241c may serve as a pixel protection layer for protecting multiple pixels of the light-emitting layer 241a.

According to an embodiment, the base film 242 may serve to support and protect the display panel 241. The base film 242 may include a flexible film made of a polymer or plastic such as polyimide or polyester (PET). In various embodiments, the base film 242 may be referred to as a "protective film", a "back film", or a "back plate".

According to an embodiment, the lower panel 243 may include multiple layers for various functions. Various polymeric gluing materials (or adhesive materials) (not illustrated separately) may be disposed between adjacent ones of multiple layers included in the lower panel 243. The lower panel 243 may include, for example, a light-blocking layer 243a, a buffer layer 243b, and/or a lower layer 243c. The light-blocking layer 243a may be disposed between the base film 242 and the buffer layer 243b. The buffer layer 243b may be disposed between the light-blocking layer 243a and the lower layer 243c. The light-blocking layer 243a may block at least some of light incident from the outside. For example, the light-blocking layer 243a may include an embossed layer. The embossed layer may be a black layer including an uneven pattern. The buffer layer 243b may alleviate an external impact applied to the flexible display 240. For example, the buffer layer 243b may include a sponge layer or a cushion layer. The lower layer 243c may diffuse, disperse, or dissipate heat generated from the foldable electronic device 2 or the flexible display 240. The lower layer 243c may absorb or block electromagnetic waves. The lower layer 243c may alleviate an external impact applied to the foldable electronic device 2 or the flexible display 240. For example, the lower layer 243c may include a composite sheet 243d or a metal sheet 243e. In an embodiment, the composite sheet 243d may be a sheet obtained by combining layers or sheets having different properties. For example, the composite sheet 243d may include at least one of polyimide or graphite. In various embodiments, the composite sheet 243d may be replaced by a single sheet including a single material (e.g., polyimide or graphite). The composite sheet 243d may be located between the buffer layer 243b and the metal sheet 243e. The metal sheet 243e may be, for example, a metal sheet. For example, the metal sheet 243e may include various other metal materials. The metal sheet 243e may suppress electromagnetic interference (EMI) to the first display module 24 or the flexible display 240. In various embodiments, at least a portion of the lower layer 243c is a conductive member (e.g., a metal plate), which may help reinforce the rigidity of the foldable electronic device 2 and may be used to block ambient noise and to dissipate heat emitted from surrounding heat-emitting components (e.g., a display driving circuit 2401) (see FIG. 4). For example, the conductive layer may include at least one of copper (Cu), aluminum (Al), stainless steel (SUS), or a CLAD (e.g., a lamination member in which SUS and Al are alternately disposed). The lower layer 243c may include various layers for various other functions.

According to various embodiments, at least one additional polymer layer (e.g., a layer including PI, PET, or TPU) (not illustrated separately) may be further disposed on the rear surface of the display panel 241 in addition to the base film 242. In various embodiments, at least one of the multiple layers included in the lower panel 243 (e.g., the light-blocking layer 243a, the buffer layer 243b, the composite sheet 243d, and the metal sheet 243e) may be omitted. In various embodiments, the arrangement order of the multiple layers included in the lower panel 243 is not limited to the illustrated embodiment and may be variously changed.

According to an embodiment, the optical layer 244 may include a polarizing layer (or a polarizer) or a retardation layer (or a retarder). The polarizer and the retardation layer may improve outdoor visibility of a screen. For example, the optical layer 244 may selectively pass light generated from a light source of the display panel 241 and oscillating in a predetermined direction. In various embodiments, a polarization layer and a retardation layer may be combined and provided as a single layer, and such a layer may be interpreted as a "circular polarizing layer".

According to various embodiments, the polarizing layer (or the circular polarizing layer) may be omitted. For example, a black pixel define layer (PDL) and/or a color filter may be provided in place of the polarizing layer.

According to an embodiment, the transparent cover 245 (e.g., a window) may protect the flexible display 240 from the outside. The transparent cover 245 may provide the front surface of the foldable electronic device 2. The transparent cover 245 may be provided in the form of a thin flexible film (e.g., a thin film layer). The transparent cover 245 may include, for example, a plastic film (e.g., a polyimide film) or thin-film glass (e.g., ultra-thin glass (UTG)). In various embodiments, the transparent cover 245 may include multiple layers. For example, the transparent cover 245 may be in the form of a plastic film or a thin glass with various coating layers disposed thereon. The transparent cover 245 may be, for example, in the form in which at least one protective layer or coating layer including a polymer material (e.g., polyester (PET), polyimide (PI), or thermoplastic polyurethane (TPU)) is disposed on a plastic film or a thin film glass.

According to various embodiments, the transparent cover 245 and the optical transparent gluing portion 246 may be interpreted as elements separate from the flexible display 240. In various embodiments, the transparent cover 245 may be interpreted as a portion of the foldable housing 20 (see FIG. 2) rather than the first display module 24.

According to an embodiment, the foldable electronic device 2 may include a touch-sensitive circuit (e.g., a touch sensor (not illustrated separately). The touch-sensitive circuit may be implemented as a transparent conductive layer (or a film) based on various conductive materials such as indium tin oxide (ITO). In an embodiment, the touch-sensitive circuit may be disposed between the transparent cover 245 and the optical layer 244 (e.g., an add-on type). In various embodiments, the touch-sensitive circuit may be disposed between the optical layer 244 and the display panel 241 (e.g., an on-cell type). In various embodiments, the display panel 241 may include a touch-sensitive circuit or a touch-sensitive function (e.g., an in-cell type).

According to various embodiments, the flexible display 240 may include a conductive pattern such as a metal mesh (e.g., an aluminum metal mesh) (not illustrated separately) as a touch-sensitive circuit disposed on the encapsulation 241c between the encapsulation 241c and the optical layer 244. In response to the bending of the flexible display 240, the metal mesh may have greater durability than the transparent conductive layer made of ITO. In various embodiments, the flexible display 240 may further include a pressure sensor (not illustrated) capable of measuring the intensity (pressure) of a touch.

According to various embodiments, the flexible display 240 may be implemented by omitting some of the components or adding other components according to the form of provision thereof or the trend of convergence. In various embodiments, the multiple layers included in the display panel 241 or the lower panel 243, or a laminating structure or laminating order thereof may vary without being limited to the illustrated example.

According to an embodiment, the support sheet (or a support plate or a support layer) 247 may be disposed on the rear surface of the flexible display 240. The rear surface of the flexible display 240 may refer to a surface located opposite to a surface from which light from the display panel 241 including multiple pixels is emitted. The support sheet 247 may be disposed (e.g., attached) on the rear surface of the lower panel 243 to cover at least a portion of the lower panel 243 of the flexible display 240. The support sheet 247 may be bonded to the lower panel 243 via a gluing material or an adhesive material. The gluing material (or adhesive material) between the flexible display 240 and the support sheet 247 may include, for example, a heat-reactive gluing material (or a heat-reactive adhesive material), a light-reactive gluing material (or a light-reactive adhesive material), an ordinary gluing agent (or an ordinary adhesive), or double-sided tape. As another example, the gluing material (or adhesive material) may include various polymers such as triazine thiol, dithio pyrimidine, or a silane-based compound, or an organic gluing material (or an organic adhesive material) such as a sealant. The support sheet 247 may contribute to durability (e.g., rigidity reinforcement) of the first display module 24. The support sheet 247 may suppress an effect of load or stress on the first display module 24 (or the flexible display 240) when the foldable electronic device 2 is in a folded state.

According to an embodiment, the support sheet 247 may include a metal material. The support sheet 247 may include, for example, stainless steel. The support sheet 247 may include various other metal materials.

According to various embodiments, the support sheet 247 may include engineering plastic.

According to an embodiment, the support sheet 247 may include a lattice structure (not illustrated) that at least partially overlaps the third area A3 (or the third display area A31) (see FIG. 4) of the first display module 24. The lattice structure may include, for example, multiple openings (or slits) provided in the support sheet 247. The lattice structure may refer to a pattern structure in which multiple openings are regularly arranged. The multiple openings may be provided periodically, may have substantially the same shape, and may be repeatedly arranged at regular intervals. The lattice structure may suppress a decrease in flexibility of the third area A3 (see FIG. 4) of the first display module 24. In various embodiments, the lattice structure including multiple openings may be referred to by another term, such as an "opening pattern", a "hole pattern", or a "lattice pattern". In various embodiments, the support sheet 247 may include a recess pattern (not illustrated) including multiple recesses in place of the lattice structure. The recess pattern may refer to a pattern structure in which multiple cut recesses provided in one surface of the support sheet 247 facing the lower panel 243 of the flexible display 240 or on the other surface of the support sheet 247 located opposite to the first surface are regularly arranged.

According to various embodiments, the lattice structure or recess pattern may extend to a portion of the support sheet 247 corresponding to the first area A1 (or the first display area A11) (see FIG. 4) of the first display module 24 and/or a portion corresponding to the second area A2 (or the second display area A21) (see FIG. 4). In various embodiments, the support sheet 247 including a lattice structure or a recessed pattern, or a conductive member corresponding thereto, may be provided in multiple layers.

According to various embodiments, the support sheet 247 may suppress electromagnetic interference (EMI) with respect to the flexible display 240.

According to various embodiments, the support sheet 247 may diffuse or dissipate heat emitted from a heat-emitting component (e.g., the display driving circuit 2401 in FIG. 4).

According to various embodiments, the support sheet 247 may be omitted.

According to various embodiments, the support sheet 247 may be interpreted as an element separate from the first display module 24.

According to an embodiment, the first display module 24 may include an extension 2402 and a first flexible printed circuit board 2403. The extension 2402 may extend from or be connected to the second border area A22 included in the second area A2 of the flexible display 240. The extension 2402 may be electrically connected to the first flexible printed circuit board 2403.

According to an embodiment, the extension 2402 may include electrical paths (e.g., wiring lines implemented by a conductive pattern) electrically interconnecting at least one TFT included in the TFT film 241b of the flexible display 240 and the first flexible printed circuit board 2403. The extension 2402 or electrical paths included in the extension 2402 may be provided by, for example, the TFT film 241b based on LTPS, LTPO, or a-Si.

According to an embodiment, the extension 2402 may not include pixels. The light-emitting layer 241a and the encapsulation 241c may not extend into the extension 2402. In various embodiments, the TFT film 241b may extend into the extension 2402, but the extension 2402 may be implemented in a form that does not include a TFT.

According to various embodiments, the light-emitting layer 241a may extend to the extension 2402, but the extension 2402 may be implemented in a form in which multiple pixels are not substantially present. In various embodiments, the encapsulation 241c may extend into the extension 2402.

According to an embodiment, the extension 2402 may include a fourth area A4 disposed between the second support 421 of the second frame 221 and the second area A2 of the flexible display 240. A gluing material (or an adhesive material) (not illustrated separately) may be disposed between the fourth area A4 of the extension 2402 and the second area A2 of the flexible display 240. The extension 2402 may include a bent area B bent and extending from the second border area A22 to the fourth area A4 of the flexible display 240.

According to an embodiment, when viewed from above the second front surface A23, the second border area A22 of the flexible display 240 may overlap the fourth area A4 of the extension 2402. The second border area A22 of the first display module 24 may include circuits or wiring lines related to the operation of the flexible display 240.

According to an embodiment, the display driving circuit 2401 (see FIG. 4) may be disposed in the fourth area A4 of the extension 2402.

According to an embodiment, one end of the first flexible printed circuit board 2403 may be electrically connected to the extension 2402. The first flexible printed circuit board 2403 may pass through an opening (not illustrated) provided in the second support 221 of the second frame 221.

According to an embodiment, the fifth area A5 of the first flexible printed circuit board 2403 may be electrically connected to the fourth area A4 of the extension 2402 and may be located between the second area A2 of the flexible display 240 and the second support 421 of the second frame 221. In an embodiment, the fourth area A4 of the extension 2402 may be disposed between the support sheet 247 and the fifth area A5 of the first flexible printed circuit board 2403. In various embodiments, when the support sheet 247 does not extend to the second area A2 or is omitted, the fourth area A4 of the extension 2402 may be disposed between the lower panel 243 of the flexible display 240 and the fifth area A5 of the first flexible printed circuit board 2403.

According to an embodiment, a gluing member (or an adhesive member) 248 may be disposed between the fifth area A5 of the first flexible printed circuit board 2403 and the second area A2 of the flexible display 240. When the support sheet 247 does not extend to the second area A2 or is omitted, the fifth area A5 may be dispose on the lower panel 243 of the flexible display 240 via the gluing member 248.

According to an embodiment, the third gluing member 263 may be at least partially disposed between the fifth area A5 of the first flexible printed circuit board 2403 and the second support 421 of the second frame 221. The third gluing member 263 may include double-sided tape, but is not limited thereto and may be various.

According to an embodiment, the third adhesive member 263 may provide waterproofing to suppress or prevent moisture from moving through a space between the fifth area A5 of the first flexible printed circuit board 2403 and the second support 421 of the second frame 221.

According to an embodiment, the thickness of the gap G between the fifth area A5 of the first flexible printed circuit board 2403 on which the third gluing member 263 is disposed and the second support 421 of the second frame 221 (e.g., the thickness in the direction in which the second front surface A23 is oriented) may be provided substantially evenly in the plane direction of the second front surface A23 (e.g., a direction parallel to the xy plane). The third gluing member 263 (e.g., double-sided tape) may have a substantially constant thickness in the plane direction of the second front surface A23 (e.g., a direction parallel to the xy plane) and may include a first gluing surface facing the fifth are A5 of the first flexible printed circuit board 2403 and a second gluing surface facing the second support 221 of the second frame 221. When the thickness of the first gap G1 between the fifth area A5 and the second support 421 is evenly provided in the plane direction of the second front surface A23, it is possible to suppress bonding defects between the first gluing surface and the fifth area A5 and bonding defects between the second gluing surface and the second support 421, thereby suppressing the deterioration of waterproofing performance.

According to an embodiment, in the second support area 421A included in the second support 421 of the second frame 221, the first bonding surface on which the third gluing member 263 is disposed may be provided as a substantially flat surface. **In** the fifth area A5 of the first flexible printed circuit board 2403, the second bonding surface on which the third gluing member 263 is disposed may be provided as a flat surface substantially parallel to the first bonding surface.

According to an embodiment, in the fifth area A5 of the first flexible printed circuit board 2403, the second bonding surface on which the third gluing member 263 is disposed may include a first bonding area corresponding to the fourth area A4 of the extension 2402 and a second bonding area corresponding to the gluing member 248. The gluing member 248 may contribute to disposing the second bonding area substantially without a height difference with respect to the first bonding area.

According to an embodiment, the fourth gluing member 264 may be disposed between the first portion 61 of the fourth frame 222 and the second border area A22 of the flexible display 240. The first portion 61 of the fourth frame 222 and the second border area A22 of the flexible display 240 may be coupled via the fourth gluing member 264. The fourth gluing member 264 may be disposed between the first portion 61 of the fourth frame 222 and the transparent cover 245 of the flexible display 240. The fourth gluing member 264 prevents foreign substances, such as moisture or dust, from flowing into the inner space of the foldable electronic device 2 through a space between the first portion 61 of the fourth frame 222 and the second border area A22 of the first display module 24.

According to various embodiments, a flexible member such as rubber or a brush may be provided in place of the fourth gluing member 264. **In** various embodiments, a porous member such as a sponge may be provided in place of the fourth gluing member 264.

According to an embodiment, the bent area B included in the extension 2402 of the first display module 24 may have a radius of curvature capable of reducing breakage due to bending stress. The bent area B may be bent with, for example, a radius of curvature that is minimized while reducing bending stress. The minimized radius of curvature of the bent area B may contribute to slimming the first display module 24.

According to various embodiments, the first display module 24 may further include a spacer (not illustrated separately) disposed between the fourth area A4 of the extension 2402 and the support sheet 247. When the support sheet 247 does not extend to the second area A2 of the flexible display 240 or is omitted, the spacer may be disposed between the fourth area A4 of the extension 2402 and the lower panel 243 of the flexible display 240. In order to suppress the bent area B of the extension 2402 from being disposed at a radius of curvature equal to or less than the corresponding radius of curvature, the spacer may increase the thickness of the area of the flexible display 240 corresponding to the fourth area A4 of the extension 2402.

According to an exemplary embodiment, the first rib 620 of the fourth frame 222 may be extend between the bent area B included in the extension 2402 of the first display module 24 and the fourth partial side surface area 422a of the second frame 221.

According to an embodiment, the support piece 27 may be disposed in the second support area 421A included in the second support 421 of the second frame 221. The support piece 27 may be disposed in a recess R (see FIG. 8) provided in the second support area 421A. The recess R (see FIG. 8) may include a first surface S1, a second surface S2, a sixth surface S6, a seventh surface S7, a ninth surface S9, and/or a tenth surface S10. The ninth surface S9 and the tenth surface S10 may be provided by the protrusion 90. The second support area 421A of the second frame 221 may include an eighth surface S8. The eighth surface S8 may include a first bonding surface on which the third gluing member 263 is disposed.

According to an embodiment, the support piece 27 may include a third surface S3, a fourth surface S4, and/or a fifth surface S5. The third surface S3 may face the first surface S1 of the second frame 221. The fourth surface S4 may be oriented substantially in the direction in which the second front surface A23 is oriented. The fifth surface S5 may face an opposite direction to the fourth surface S4. The fifth surface S5 may face the seventh surface S7 of the second frame 221.

According to an embodiment, the first gluing member 261 may be disposed between the seventh surface S7 of the second frame 221 and the fifth surface S5 of the support piece 27. The support piece 27 may be bonded to the seventh surface S7 of the second frame 221 via the first gluing member 261. The first gluing member (or the second adhesive member) 261 may include a heat-reactive gluing material (or a heat-reactive adhesive material), a light-reactive adhesive material (or a light-reactive adhesive material), an ordinary gluing agent (or an ordinary adhesive), or double-sided tape. In various embodiments, the first gluing member (or the first adhesive member) 261 may include various polymers such as triazine thiol, dithio pyrimidine, or a silane-based compound, or an organic gluing material (or an organic adhesive material) such as a sealant.

According to an embodiment, the fourth surface S4 of the support piece 27 may be located to be higher than the eighth surface S8 of the second frame 221 in a direction in which the second front surface A23 is oriented.

According to an embodiment, when viewed from above the second front surface A23, the third gluing member 263 may overlap the second display area A21 of the flexible display 240 and may not overlap the second border area A22 of the flexible display 240. In various embodiments, when viewed from above the second front surface A23, the third gluing member 263 may overlap the second border area A22 of the flexible display 240 (not illustrated separately).

According to an embodiment, when viewed from above the second front surface A23, the fifth area A5 of the first flexible printed circuit board 2403 may overlap the fourth surface S4 of the support piece 27 and the eighth surface S8 of the second frame 221. The first gap G1 may be provided between the fifth area A5 of the first flexible printed circuit board 2403 and the fourth surface S4 of the support piece 27. Due to the height difference between the fourth surface S4 and the eighth surface S8, the first gap G1 may have a smaller thickness than the second gap G2 in the direction in which the second front surface A23 is oriented. The third gluing member 263 (e.g., double-sided tape) may have a substantially constant thickness in the plane direction of the second front surface A23 (e.g., a direction parallel to the xy plane). In order to suppress or prevent bonding defects due to a difference in thickness between the first gap G1 and the second gap G2 and a decrease in waterproofing performance due to the bonding defects, the third gluing member 263 may not extend into the second gap G2. When viewed from above the second front surface A23, the third gluing member 263 may not overlap the fourth surface S4 of the support piece 27.

According to various embodiments, the fourth surface S4 of the support piece 27 may be located to be lower than the eighth surface S8 of the second frame 221 in a direction in which the second front surface A23 is oriented (not illustrated separately). In order to suppress or prevent bonding defects due to a difference in thickness between the first gap G1 and the second gap G2 and a decrease in waterproofing performance due to the bonding defects, the third gluing member 263 may not extend into the second gap G2. When viewed from above the second front surface A23, the third gluing member 263 may not overlap the fourth surface S4 of the support piece 27.

According to various embodiments, the fourth surface S4 of the support piece 27 and the eighth surface S8 of the second frame 221 may be provided without a substantial difference in height in the direction in which the second front surface A23 is oriented (not illustrated separately). There may be substantially no difference in thickness between the first gap G1 and the second gap G2. For example, the third gluing member 263 may further extend into the second gap G2 (not illustrated separately). When viewed from above the second front surface A23, the third gluing member 263 may overlap the fourth surface S4 of the support piece 27.

According to an embodiment, when viewed from above the second front surface A23, the fourth surface S4 of the support piece 27 may overlap the fifth area A5 of the first flexible printed circuit board 2403.

According to various embodiments, when viewed from above the second front surface A23, the fourth surface S4 of the support piece 27 may not overlap the fifth area A5 of the first flexible printed circuit board 2403 (not illustrated separately).

According to an embodiment, when viewed from above the second front surface A23, the fourth area A4 of the extension 2402 included in the first display module 24 may overlap the fourth surface S4 of the support piece 27.

According to various embodiments, when viewed from above the second front surface A23, the fourth area A4 of the extension 2402 included in the first display module 24 and the fourth surface S4 of the support piece 27 may not overlap each other (not illustrated separately).

According to an embodiment, when viewed from above the second front surface A23, the bent area B of the extension 2402 included in the first display module 24 may overlap the fourth surface S4 of the support piece 27.

According to an embodiment, the bent area B of the extension 2402 included in the first display module 24 may be at least partially located between the first portion 61 of the fourth frame 222 and the support piece 27.

According to an embodiment, a separation space between the fourth surface S4 of the support piece 27 and the first display module 24 may be provided in the direction in which the second front surface A23 is oriented. The separation space provided between the fourth surface S4 of the support piece 27 and the first display module 24 in the direction in which the second front surface A23 is oriented may be provided to suppress or prevent the support piece 27 from colliding with the first display module 24 (or the bent area B of the extension 2402) in the event of an external impact due to a drop.

According to various embodiments, the fourth surface S4 of the support piece 27 may be provided as an inclined surface forming an acute angle or an obtuse angle with the direction in which the second front surface A23 is oriented (not illustrated separately).

According to various embodiments, the fourth surface S4 of the support piece 27 may include a curved surface (not illustrated separately). The fourth surface S4 may include a curved surface corresponding to the bent area B of the extension 2402 included in the first display module 24.

According to an embodiment, the fourth surface S4 of the support piece 27 may be located to be higher than the tenth surface S10 of the second frame 221 in a direction in which the second front surface A23 is oriented.

According to an embodiment, through the combination of the second frame 221 and the support piece 27, a recessed space 1101 or 1102 into which the first rib area 621 of the first rib 620 is inserted may be provided. The first partial rib area 621a (see FIG. 6) included in the first rib area 621 of the first rib 620 may be inserted into the space 1101 between the third surface S3 of the support piece 27 and the first surface S1 of the second frame 221. The first partial rib area 621a (see FIG. 6) included in the first rib area 621 of the first rib 620 may extend from the first portion 61 of the fourth frame 222 toward the tenth surface S10 of the second frame 221. The second partial rib area 621b (see FIG. 6) included in the first rib area 621 of the first rib 620 may be inserted into the space 1102 between the third surface S3 and the first surface S1. The second partial rib area 621b (see FIG. 6) included in the first rib area 621 of the first rib 620 may extend from the first portion 61 of the fourth frame 222 toward the seventh surface S7 of the second frame 221.

According to various embodiments, the fourth surface S4 of the support piece 27 and the tenth surface S10 of the second frame 221 may be provided without a substantial difference in height (not illustrated separately). For example, the space 1101 between the third surface S3 of the support piece 27 and the first surface S1 of the second frame 221 may be omitted.

According to various embodiments, the fourth surface S4 of the support piece 27 may be located to be lower than the tenth surface S10 of the second frame 221 in a direction in which the second front surface A23 is oriented (not illustrated separately). For example, the space 1101 between the third surface S3 of the support piece 27 and the first surface S1 of the second frame 221 may be omitted.

Although not illustrated separately, a cross-sectional view of the foldable electronic device 2 taken along the line G-G' in FIG. 11 may be substantially the same as the cross-sectional view of FIG. 14. Although not illustrated separately, a cross-sectional view of the foldable electronic device 2 taken along the line H-H' in FIG. 11 may be substantially the same as the cross-sectional view of FIG. 15.

According to an embodiment, the second gluing member 262 may be disposed in the second recess area R2 of the second frame 221. The second portion 62 may be coupled to the foldable housing 20 via a second gluing member 262 disposed in the recess R. Thereby, the coupling of the second portion 62 to the foldable housing 20 enhances the distribution of the impact through the foldable housing 20 in case of the external impact applied to the flexible display 240. An end of the second rib area 622 of the first rib 620 disposed in the second recess area R2 may be fixed to the second frame 221 via the second gluing member 262. The second gluing member (or the second adhesive member) 262 may include a heat-reactive gluing material (or a heat-reactive adhesive material), a light-reactive adhesive material (or a light-reactive adhesive material), an ordinary gluing agent (or an ordinary adhesive), or double-sided tape. The second gluing member (or the second adhesive member) 262 may include various polymers such as triazine thiol, dithio pyrimidine, or a silane-based compound, or an organic gluing material (or an organic adhesive material) such as a sealant. In various embodiments, the second gluing member 262 may include a liquid-type gasket (cured in place gaskets (CIPG)).

According to an embodiment, the third rib area 623 (see FIG. 6) of the first rib 620 may be fixed to the second frame 221 via a gluing member (or an adhesive member) (not illustrated separately) disposed in the third recess area R3 (see FIG. 11). The gluing member disposed in the third recess area R3 (see FIG. 11) may be made of, for example, the same material as the second gluing member 262.

According to various embodiments, the first rib area 621 of the first rib 620 may be fixed to the support piece 27 and the second frame 221 via a gluing member (or an adhesive member (not illustrated separately) disposed in the space 1101 between the third surface S3 of the support piece 27 and the first surface S1 of the second frame 221. The adhesive member disposed in the space 1101 between the third surface S3 of the support piece 27 and the first surface S1 of the second frame 221 may be the same material as, for example, the second gluing member 262.

According to various embodiments, the first rib area 621 of the first rib 620 may be fixed to the second frame 221 via a gluing member (or an adhesive member) (not illustrated separately) disposed in the space 1102 between the third surface S3 of the support piece 27 and the first surface S1 of the second frame 221. The first rib area 621 of the first rib 620 may be fixed to the second frame 221 via a gluing member (or an adhesive member) (not illustrated separately) disposed in the space 1103 (see

FIG. 11) between the third surface S3 of the support piece 27 and the first surface S1 of the second frame 221. The adhesive member disposed in the space 1102 between the third surface S3 of the support piece 27 and the first surface S1 of the second frame 221 may be the same material as, for example, the second gluing member 262. The adhesive member disposed in the space 1103 (see FIG. 11) between the third surface S3 of the support piece 27 and the first surface S1 of the second frame 221 may be the same material as, for example, the second gluing member 262.

According to an embodiment, the recessed space 1101, 1102, or 1103 in FIG. 11 provided through the combination of the second frame 221 and the support piece 27 may have a width capable of suppressing loose insertion (or loose fit) of the first rib area 621 of the first rib 620. In an embodiment, the recessed space 1101, 1102, or 1103 in FIG. 11 provided through the combination of the second frame 221 and the support piece 27 may reduce a positional deviation between the second frame 221 and the fourth frame 222.

FIG. 16 is a view illustrating a second frame 1610 and a support piece 1620 according to various embodiments of the disclosure.

Referring to FIG. 16, the second frame 1610 may be provided by at least partially modifying the second frame 221 of FIG. 11. The support piece 1620 may be provided by at least partially modifying the support piece 27 of FIG. 11. Although not illustrated separately, the fourth frame may be provided in a form corresponding to the second frame 1610 and the support piece 1620. The fourth frame may be provided by at least partially modifying the fourth frame 222 of FIG. 6.

According to various embodiments, the second frame 1610 may include a fourth partial side surface area 1611 (e.g., the fourth partial side surface area 422a in FIG. 11) and a second support 1612 (e.g., the second support 421 in FIG. 11). The second frame 1610 may include a recess 1630 (e.g., the recess R in FIG. 9) into which a rib (e.g., the first rib 620 in FIG. 7) of the fourth frame is inserted. The recess 1630 may include a first recess area 1631 (e.g., the first recess area R1 in FIG. 9), a second recess area 1632 (e.g., the second recess area R2 in FIG. 9), and/or a third recess area 1633 (e.g., the third recess area R3 in FIG. 9). When viewed from above the second display area A21 (see FIG. 2) of the flexible display 240, the first recess area 1631 may include a central area 1631b (e.g., the central area R12 in FIG. 9) between the second recess area 1632 and the third recess area 1633 and an extension area 1631a (e.g., the extension area R11 in FIG. 9) extending from the central area 1631b.

According to various embodiments, the second frame 1610 may not include the protrusion 90 compared with the second frame 221 according to the embodiment of FIG. 11.

According to various embodiments, a portion of the support piece 1620 may be disposed in the extension area 1631a of the first recess area 1631, and the remaining portion of the support piece 1620 may be disposed in the central area 1631b of first recess area 1631.

According to various embodiments, the support piece 1620 may be provided in a form further including a first extension area 1621 and a second extension area 1622 extending from the portion of the support piece 1620 disposed in the extension area 1631a of the first recess area 1631 compared with the second piece 27 according to the embodiment of FIG. 11. The first recess area 1631 included in the recess 1630 of the second frame 221 may include an extension area 1631a implemented to further include an area corresponding to the first extension area 1621 and the second extension area 1622 of the support piece 1620 compared to the first recess area R1 according to the embodiment of FIG. 9. The extension area 1631a of the first recess area 1631 and a portion of the support piece 1620 disposed in the extension area 1631a may suppress separation of the support piece 1620 without the protrusion 90 (see FIG. 11).

According to various embodiments, the support piece 1620 may be provided in a form in which one of the first extension area 1621 and the second extension area 1622 is omitted, and the first recess area 1631 may be provided in a form corresponding to that of the support piece 1620.

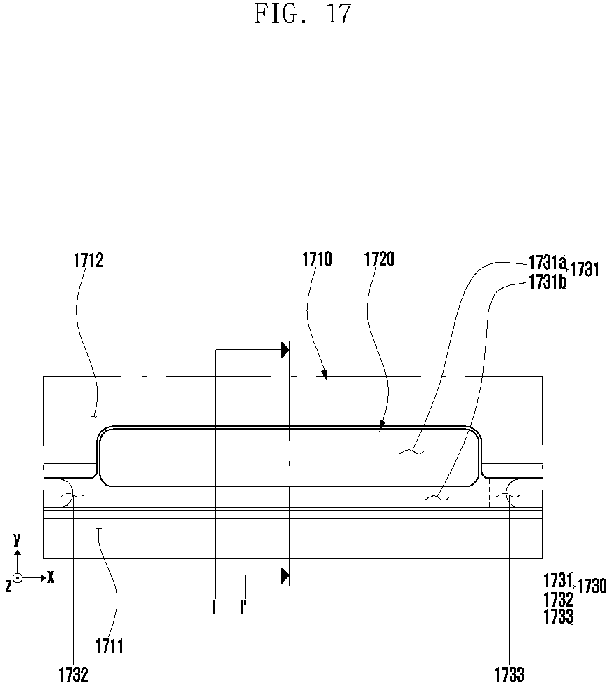

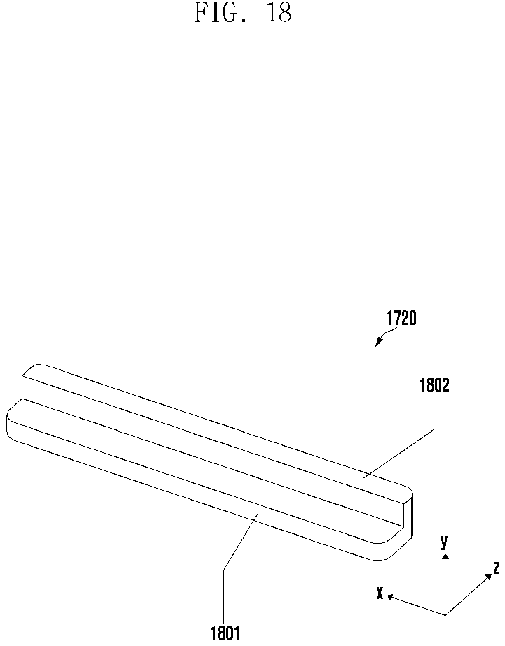

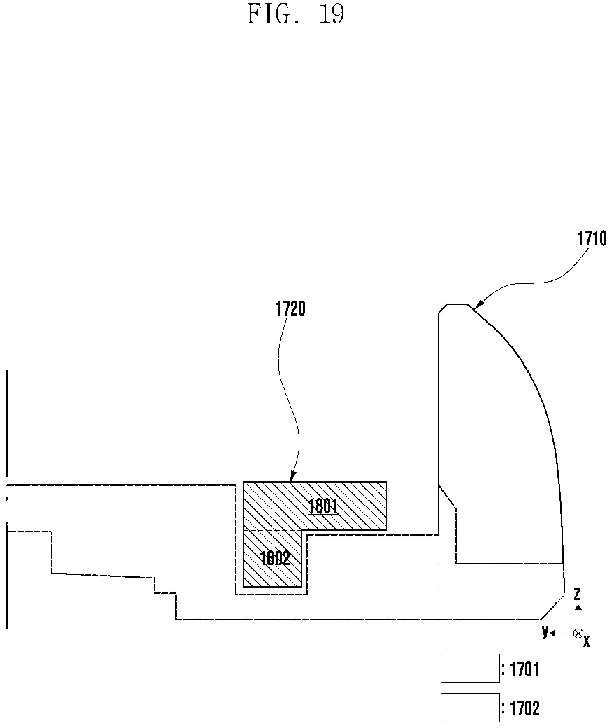

FIG. 17 is a view illustrating a second frame 1710 and a support piece 1720 according to various embodiments of the disclosure. FIG. 18 is a perspective view illustrating a support piece 1720 according to various embodiments of the disclosure. FIG. 19 is a cross-sectional view illustrating the second frame 1710 and the support piece 1720 according to an embodiment of the disclosure taken along line I-I' in FIG. 17.

Referring to FIGS. 17, 18, and 19, the second frame 1710 may be provided by at least partially modifying the second frame 221 of FIG. 11. The support piece 1720 may be provided by at least partially modifying the support piece 27 of FIG. 11. Although not illustrated separately, the fourth frame may be provided in a form corresponding to the second frame 1710 and the support piece 1720. The fourth frame may be provided by at least partially modifying the fourth frame 222 of FIG. 6.

According to various embodiments, the second frame 1710 may include a fourth partial side surface area 1711 (e.g., the fourth partial side surface area 422a in FIG. 11) and a second support 1712 (e.g., the second support 421 in FIG. 11). The second frame 1710 may be provided as a combination of a conductive area 1701 (e.g., the conductive area 51 in FIG. 8) and a non-conductive area 1702 (e.g., the non-conductive area 52 in FIG. 8). The second frame 1710 may include a recess 1730 (e.g., the recess R in FIG. 9) into which a rib (e.g., the first rib 620 in FIG. 7) of the fourth frame is inserted. The recess 1730 may include a first recess area 1731 (e.g., the first recess area R1 in FIG. 9), a second recess area 1732 (e.g., the second recess area R2 in FIG. 9), and/or a third recess area 1733 (e.g., the third recess area R3 in FIG. 9). When viewed from above the second display area A21 (see FIG. 2) of the flexible display 240, the first recess area 1731 may include a central area 1731b (e.g., the central area R12 in FIG. 9) between the second recess area 1732 and the third recess area 1733 and an extension area 1731a (e.g., the extension area R11 in FIG. 9) extending from the central area 1731.

According to various embodiments, the second frame 1710 may not include the protrusion 90 compared with the second frame 221 according to the embodiment of FIG. 11.

According to various embodiments, a portion of the support piece 1720 may be disposed in the extension area 1731a of the first recess area 1731, and the remaining portion of the support piece 1720 may be disposed in the central area 1731b of first recess area 1731.

According to various embodiments, the support piece 1720 may include a third portion 1801 and a fourth portion 1804. The third portion 1801 may have substantially the same shape as, for example, the support piece 27 according to the embodiment of FIG. 11. The fourth portion 1804 may extend from the third portion 1801 and may be disposed between the third portion 1801 and the second support 1712 of the second frame 1710. The extension area 1731a of the first recess area 1731 may further include a groove into which the fourth portion 1804 may be fitted (or inserted) compared with the extension area R11 of the first recess area R1 according to the embodiment of FIG. 9. The extension area 1731a of the first recess area 1731 and a portion of the support piece 1720 disposed in the extension area 1731a may suppress separation of the support piece 1720 without the protrusion 90 (see FIG. 11).

In various embodiments, the fourth portion 1804 of the support piece 1720 may be bonded to the second frame 1710 via a gluing member (e.g., the first gluing member 261 in FIG. 13).

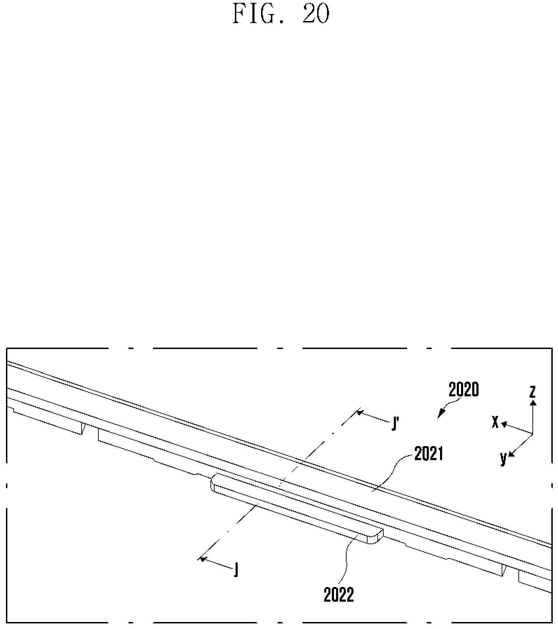

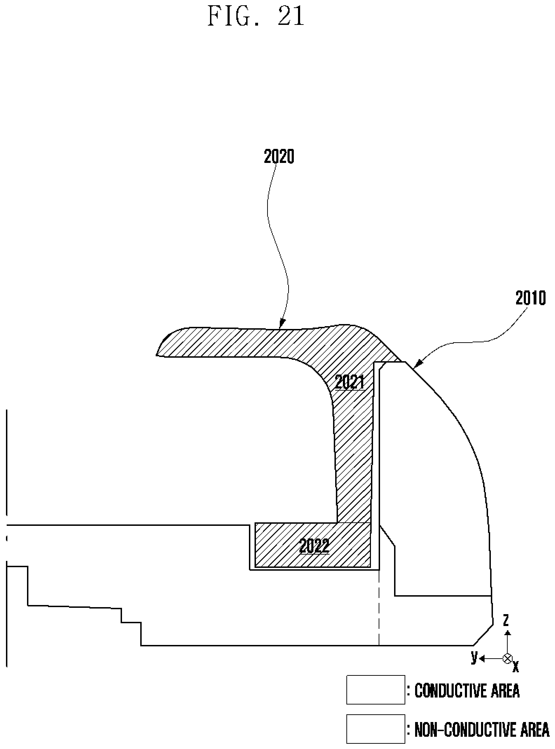

FIG. 20 is a perspective view of a fourth frame 2020 according to various embodiments of the disclosure. FIG. 21 is a cross-sectional view illustrating the second frame 2010 and the fourth frame 2020 according to an embodiment of the disclosure taken along line J-J' in FIG. 20.

Referring to FIGS. 20 and 21, the second frame 2010 may be provided by at least partially modifying the second frame 221 of FIG. 11. The fourth frame 2020 may correspond to that obtained by integrally implementing the fourth frame 222 and the support piece 27 according to the embodiment of FIG. 5. The fourth frame 2020 may include a portion 2021 corresponding to the fourth frame 222 of FIG. 5 and a remaining portion 2022 corresponding to the support piece 27 of FIG. 5.

According to various embodiments, the disclosure illustrates a foldable electronic device 2 but is not limited thereto. The scope of various embodiments of the disclosure may be applied to a bar-type or plate-type electronic device, a slidable electronic device, a stretchable electronic device, and/or a rollable electronic device.

According to an exemplary embodiment of the disclosure, an electronic device (e.g., the foldable electronic device 2) includes a housing (e.g., the foldable housing 20 or the second housing 22), a display module (e.g., the first display module 24), a support piece 27, and a frame (e.g., the fourth frame 222). However, it is pointed out that the support piece 27 is optionally provided to perform this embodiment and can be replaced to the support piece 1620 or the support piece 1720. The housing (e.g., the foldable housing 20 or the second housing 22) includes a support (e.g., the second support 421) and a side surface area (e.g., the second side surface area 422) connected to or extending from the support and providing at least a portion (e.g., the second side surface) of a side surface of the electronic device. The display module is disposed on the housing. The display module includes a display (e.g., the flexible display 240) and an extension 2402. The support (e.g., the second support 421) supports the rear surface of the display. The extension includes a partial area (e.g., the fourth area A4) disposed between the support (e.g., the second support 421) and the display and a bent area B bent and extending from the display to the partial area (e.g., the fourth area A4) and from the display to the partial area (e.g., the fourth area A4). The support piece is disposed in the recess R provided in the support (e.g., the second support 421). The frame (e.g., the fourth frame 222) is coupled to the housing. The frame (e.g., the fourth frame 222) includes a first portion 61 and a second portion 62. The first portion covers a border area (e.g., the second edge area A22) of the display and is exposed to the outside. The second portion extends from the first portion to a space between the bent area B of the extension 2402 and the side surface area (e.g., the second side surface area 422) of the housing 20. The second portion 62 is configured to be inserted into a space between the support piece 27 and the side surface area in the recess R.

According to an exemplary embodiment of the disclosure, the recess R may include a first surface S1 and a second surface S2 facing the first surface S1 and spaced apart from the first surface S1 by a second distance W2 in a first direction. The support piece 27 may provide a third surface S3 facing the first surface S1. The third surface S3 may be spaced apart from the first surface S1 by a first distance W1 in the first direction, wherein the first distance W1 is smaller than the second distance W2. When viewed from above the display area (e.g., the second display area A21) of the display (e.g., the flexible display 240), a first space between the first surface S1 and the third surface S3 may not overlap a second space between the first surface S1 and the second space S2. The second portion 62 may be inserted into the first space and the second space.

According to an exemplary embodiment of the disclosure, the housing (e.g., the foldable housing 20 or the second housing 22) may include a protrusion 90 extending from the side surface area (e.g., the second side surface area 422) toward the support piece 27 when viewed from the display area (e.g., the second display area A21) of the display (e.g., the flexible display 240). The protrusion 90 may be disposed in the recess R. The protrusion 90 can support the support piece 27.

According to an exemplary embodiment of the disclosure, the bent area B of the extension 2402 may be disposed between the first portion 61 of the frame (e.g., the fourth frame 222) and the support piece 27.

According to an exemplary embodiment of the disclosure, the second portion 62 of the frame (e.g., the fourth frame 222) may include a notch 6211 corresponding to the protrusion 90.

According to an exemplary embodiment of the disclosure, when viewed from above the display area (e.g., the second display area A21) of the display (e.g., the flexible display 240), the bent area B of the extension 2402 may overlap the support piece 27. The support piece 27 may be spaced apart from the display module (e.g., the first display module 24).

According to an exemplary embodiment of the disclosure, the electronic device (e.g., the foldable electronic device 2) may further include a first gluing member 261 disposed between the support piece 27 and the housing (e.g., the foldable housing 20 or the second housing 22).

According to an exemplary embodiment of the disclosure, the second portion 62 of the frame (e.g., the fourth frame 222) may be connected to the support piece 27.

According to an exemplary embodiment of the disclosure, the second portion 62 may be coupled to the housing (e.g., the foldable housing 20 or the second housing 22) via the second gluing member 262 disposed in the recess R.

According to an exemplary embodiment of the disclosure, the display module (e.g., the first display module 24) may further include a first flexible printed circuit board 2403 electrically connected to the extension 2402. A partial area (e.g., the fifth area A5) of the first flexible printed circuit board 2403 may be disposed between the support (e.g., the second support 421) and the display (e.g., the flexible display 240) and may be coupled to the support (e.g., the second support 421) via a third gluing member 263. The third gluing member 263 may not overlap the support piece 27 when viewed from above the display area (e.g., the second display area A21) of the display (e.g., the flexible display 240).

According to an exemplary embodiment of the disclosure, the electronic device (e.g., the foldable electronic device 2) may further include a display driving circuit 2401 disposed in the partial area (e.g., the fourth area A4) of the extension 2402 disposed between the support (e.g., the second support 421) and the display (e.g., the flexible display 240).

According to an exemplary embodiment of the disclosure, at least one conductive portion included in the side surface area (e.g., the second side surface area 422) may be electrically connected to the wireless communication circuit (e.g., the wireless communication module 192 in FIG. 1). The frame (e.g., the fourth frame 222) may include a non-conductive material.

According to an exemplary embodiment of the disclosure, the combination of the first portion 61 and the side surface area 422 may provide a bezel (e.g., the second bezel B2) that at least partially surrounds the display area (e.g., the second display area A21) of the display (e.g., the flexible display 240) when viewed from above the display area (e.g., the second display area A21) of the display (e.g., the flexible display 240).

According to an exemplary embodiment of the disclosure, the housing may be a foldable housing 20 configured to fold the display module (e.g., the first display module 24).

According to an exemplary embodiment of the disclosure, the housing (e.g., the foldable housing 20) may include a first housing 21, a second housing 22, and a hinge H interconnecting the first housing 21 and the second housing 22. The display (e.g., the flexible display 240) may include a first area A1 disposed in the first housing 21, a second area A2 disposed in the second housing 22, and a third area A3 interconnecting the first area A1 and the second area A2 and located to correspond to the hinge H. The electronic device (e.g., the foldable electronic device 2) may further include a first printed circuit board 451 disposed on the first housing 21, a second printed circuit board 452 disposed on the second housing 22, and a second flexible printed circuit board 471 disposed across the hinge H and electrically interconnecting the first printed circuit board 451 and the second printed circuit board 452. The extension 2402 of the display module (e.g., the first display module 24) may extend from the second area A2. The display (e.g., the flexible display 240) may be electrically connected to the second printed circuit board 452 via the extension 2402.

Embodiments disclosed in the disclosure and drawings are merely presented as specific examples to easily describe a technical content and help understanding of the disclosure, and are not intended to limit the scope of the disclosure. Accordingly, the scope of the various embodiments of the disclosure should be construed as including changes or modifications of the embodiments in addition to the embodiments disclosed herein. In addition, it will be appreciated that any embodiment(s) described herein may be used with any other embodiment(s) described herein.

## Claims

1. An electronic device (2) comprising:
a housing (20) comprising a support (421) and a side surface area (422) connected to or extending from the support (421), the side surface area (422) being configured to provide at least a portion of a side surface of the electronic device (2);
a display module (24) disposed on the housing (20), wherein the display module (24) comprises
a display (240) comprising a rear surface supported by the support (421), and
an extension (2402) comprising a partial area (A4) disposed between the support (421) and the display (240) and a bent area (B) bent and extending from the display (240) to the partial area (A4);
a support piece (27) disposed in a recess (R) provided in the support (421); and
a frame (222) coupled with the housing (20), wherein the frame (222) comprises
a first portion (61) that covers a border area (A22) of the display (240) and is exposed to outside, and
a second portion (62) extending from the first portion (61) to a space between the bent area (B) of the extension (2402) and the side surface area (422) of the housing (20), **characterized in that**
the second portion (62) configured to be inserted into a space between the support piece (27) and the side surface area (422) in the recess (R).

2. The electronic device of claim 1, wherein the recess (R) comprises a first surface (S1) and a second surface (S2) facing the first surface (S1) and spaced apart from the first surface (S1) in a first direction by a second distance W2,
wherein the support piece (27) provides a third surface (S3) facing the first surface (S1),
wherein the third surface (S3) is spaced apart from the first surface (S1) in the first direction by a first distance (W1) smaller than the second distance (W2),
wherein a first space between the first surface (S1) and the third surface (S3) does not overlap a second space between the first surface (S1) and the second surface (S2) in a view from above a display area (A21) of the display (240), and
wherein the second portion (62) is inserted into the first space and the second space.

3. The electronic device of claim 1 or 2, wherein the housing (20) comprises a protrusion (90) extending from the side surface area (422) toward the support piece (27) in a view from above a display area (A21) of the display (240), and
wherein the protrusion (90) is disposed in the recess (R) and supports the support piece (27).

4. The electronic device of claim 3, wherein the second portion (62) of the frame (222) comprises a notch corresponding to the protrusion (90).

5. The electronic device of any one of claims 1 to 4, wherein the bent area (B) of the extension (2402) is disposed between the first portion (61) of the frame (222) and the support piece (27).

6. The electronic device of any one of claims 1 to 5, wherein the bent area (B) of the extension (2402) overlaps the support piece (27) in a view from above a display area (A21) of the display (240), and
wherein the support piece (27) is spaced apart from the display module (24).

7. The electronic device of any one of claims 1 to 6, further comprising a first gluing member (261) disposed between the support piece (27) and the housing (20).

8. The electronic device of any one of claims 1 to 7, wherein the second portion (62) of the frame (222) is connected to the support piece (27).

9. The electronic device of any one of claims 1 to 8, wherein the second portion (62) is coupled to the housing (20) via a second gluing member (262) disposed in the recess (R).

10. The electronic device of any one of claims 1 to 9, wherein the display module (24) further comprises a first flexible printed circuit board (2403) electrically connected to the extension (2402),
wherein a partial area (A5) of the first flexible printed circuit board (2403) is disposed between the support (421) and the display (240) and coupled to the support (421) via a third gluing member (263), and
wherein the third gluing member (263) does not overlap the support piece (27) in a view from above a display area (A21) of the display (240).

11. The electronic device of any one of claims 1 to 10, further comprising a display driving circuit (2401) disposed in the partial area (A4) of the extension (2402) disposed between the support (421) and the display (240).

12. The electronic device of any one of claims 1 to 11, wherein at least one conductive portion comprised in the side surface area (422) is electrically connected to a wireless communication circuit, and
wherein the frame (222) comprises a non-conductive material.

13. The electronic device of any one of claims 1 to 12, wherein a combination of the first portion (61) and the side surface area (422) provides a bezel (B2) that at least partially surrounds a display area (A21) of the display (240) in a view from above the display (240).

14. The electronic device of any one of claims 1 to 13, wherein the housing (20) is a foldable housing configured to fold the display module (24).

15. The electronic device of any one of claims 1 to 14, wherein the housing (20) comprises a first housing (21), a second housing (22), and a hinge (H) interconnecting the first housing (21) and the second housing (22),
wherein the display (240) comprises a first area (A1) disposed on the first housing (21), a second area (A2) disposed on the second housing (22), and a third area (A3) interconnecting the first area (A1) and the second area (A2) and located to correspond to the hinge (H),
wherein the electronic device (2) further comprises a first printed circuit board (451) disposed in the first housing (21), a second printed circuit board (452) disposed in the second housing (22), and a second flexible printed circuit board (471) disposed across the hinge (H) and electrically interconnecting the first printed circuit board (451) and the second printed circuit board (452),
wherein the extension (2402) of the display module (24) extends from the second area (A2), and
wherein the display (240) is electrically connected to the second printed circuit board (452) via the extension (2402).

## Patentansprüche

1. Elektronische Vorrichtung (2), umfassend:
ein Gehäuse (20), das einen Träger (421) und eine Seitenoberfläche (422) umfasst, die mit dem Träger (421) verbunden ist oder sich von diesem erstreckt, wobei die Seitenoberfläche (422) so konfiguriert ist, dass sie mindestens einen Abschnitt einer Seitenfläche der elektronischen Vorrichtung (2) bereitstellt;
ein an dem Gehäuse (20) angeordnetes Anzeigemodul (24), wobei das Anzeigemodul (24) Folgendes umfasst
eine Anzeige (240), die eine von dem Träger (421) getragene Rückfläche umfasst, und
eine Verlängerung (2402), die einen Teilbereich (A4), der zwischen dem Träger (421) und der Anzeige (240) angeordnet ist, und einen gebogenen Bereich (B) umfasst, der gebogen ist und sich von der Anzeige (240) zum Teilbereich (A4) erstreckt;
ein Trägerstück (27), das in einer in dem Träger (421) bereitgestellten Aussparung (R) angeordnet ist; und
einen mit dem Gehäuse (20) gekoppelten Rahmen (222), wobei der Rahmen (222) Folgendes umfasst
einen ersten Abschnitt (61), der einen Grenzbereich (A22) der Anzeige (240) abdeckt und nach außen freigelegt ist, sowie
einen zweiten Abschnitt (62), der sich vom ersten Abschnitt (61) zu einem Raum zwischen dem gebogenen Bereich (B) der Verlängerung (2402) und der Seitenoberfläche (422) des Gehäuses (20) erstreckt, **dadurch gekennzeichnet, dass** der zweite Abschnitt (62) so konfiguriert ist, dass er in einen Raum zwischen dem Trägerstück (27) und der Seitenoberfläche (422) in der Aussparung (R) einsetzbar ist.

2. Elektronische Vorrichtung nach Anspruch 1, wobei die Aussparung (R) eine erste Fläche (S1) und eine zweite Fläche (S2) umfasst, die der ersten Fläche (S1) zugewandt ist und in einer ersten Richtung um einen zweiten Abstand W2 von der ersten Fläche (S1) beabstandet ist,
wobei das Trägerstück (27) eine dritte Fläche (S3) bereitstellt, die der ersten Fläche (S1) zugewandt ist,
wobei die dritte Fläche (S3) in der ersten Richtung um einen ersten Abstand (W1) von der ersten Fläche (S1) beabstandet ist, der kleiner ist als der zweite Abstand (W2),
wobei sich in einer Draufsicht auf einen Anzeigebereich (A21) der Anzeige (240) ein erster Raum zwischen der ersten Fläche (S1) und der dritten Fläche (S3) nicht mit einem zweiten Raum zwischen der ersten Fläche (S1) und der zweiten Fläche (S2) überlappt, und
wobei der zweite Abschnitt (62) in den ersten Raum und den zweiten Raum eingesetzt ist.

3. Elektronische Vorrichtung nach Anspruch 1 oder 2, wobei das Gehäuse (20) einen Vorsprung (90) umfasst, der sich in einer Draufsicht auf einen Anzeigebereich (A21) der Anzeige (240) von der Seitenoberfläche (422) in Richtung des Trägerstücks (27) erstreckt, und
wobei der Vorsprung (90) in der Aussparung (R) angeordnet ist und das Trägerstück (27) trägt.

4. Elektronische Vorrichtung nach Anspruch 3, wobei der zweite Abschnitt (62) des Rahmens (222) eine der Kerbe umfasst, die dem Vorsprung (90) entspricht.

5. Elektronische Vorrichtung nach einem der Ansprüche 1 bis 4, wobei der gebogene Bereich (B) der Verlängerung (2402) zwischen dem ersten Abschnitt (61) des Rahmens (222) und dem Trägerstück (27) angeordnet ist.

6. Elektronische Vorrichtung nach einem der Ansprüche 1 bis 5, wobei der gebogene Bereich (B) der Verlängerung (2402) in einer Draufsicht auf einen Anzeigebereich (A21) der Anzeige (240) das Trägerstück (27) überlappt, und
wobei das Trägerstück (27) von dem Anzeigemodul (24) beabstandet ist.

7. Elektronische Vorrichtung nach einem der Ansprüche 1 bis 6, ferner umfassend ein erstes Klebeelement (261), das zwischen dem Trägerstück (27) und dem Gehäuse (20) angeordnet ist.

8. Elektronische Vorrichtung nach einem der Ansprüche 1 bis 7, wobei der zweite Abschnitt (62) des Rahmens (222) mit dem Trägerstück (27) verbunden ist.

9. Elektronische Vorrichtung nach einem der Ansprüche 1 bis 8, wobei der zweite Abschnitt (62) über ein zweites Klebeelement (262), das in der Aussparung (R) angeordnet ist, mit dem Gehäuse (20) gekoppelt ist.

10. Elektronische Vorrichtung nach einem der Ansprüche 1 bis 9, wobei das Anzeigemodul (24) ferner eine erste flexible Leiterplatte (2403) umfasst, die elektrisch mit der Verlängerung (2402) verbunden ist,
wobei ein Teilbereich (A5) der ersten flexiblen Leiterplatte (2403) zwischen dem Träger (421) und der Anzeige (240) angeordnet ist und über ein drittes Klebeelement (263) mit dem Träger (421) gekoppelt ist, und
wobei das dritte Klebeelement (263) das Trägerstück (27) in einer Draufsicht auf einen Anzeigebereich (A21) der Anzeige (240) nicht überlappt.

11. Elektronische Vorrichtung nach einem der Ansprüche 1 bis 10, ferner umfassend eine Anzeigeantriebsschaltung (2401), die in dem Teilbereich (A4) der Verlängerung (2402) angeordnet ist, der zwischen dem Träger (421) und der Anzeige (240) angeordnet ist.

12. Elektronische Vorrichtung nach einem der Ansprüche 1 bis 11, wobei mindestens ein in der Seitenoberfläche (422) umfasster leitfähiger Abschnitt elektrisch mit einer drahtlosen Kommunikationsschaltung verbunden ist, und
wobei der Rahmen (222) ein nicht leitfähiges Material umfasst.

13. Elektronische Vorrichtung nach einem der Ansprüche 1 bis 12, wobei eine Kombination aus dem ersten Abschnitt (61) und der Seitenoberfläche (422) eine Einfassung (B2) bereitstellt, die in einer Draufsicht auf die Anzeige (240) einen Anzeigebereich (A21) der Anzeige (240) mindestens teilweise umgibt.

14. Elektronische Vorrichtung nach einem der Ansprüche 1 bis 13, wobei das Gehäuse (20) ein faltbares Gehäuse ist, das konfiguriert ist, um das Anzeigemodul (24) zu falten.

15. Elektronische Vorrichtung nach einem der Ansprüche 1 bis 14, wobei das Gehäuse (20) ein erstes Gehäuse (21), ein zweites Gehäuse (22) und ein Scharnier (H) umfasst, das das erste Gehäuse (21) und das zweite Gehäuse (22) miteinander verbindet,
wobei die Anzeige (240) einen ersten Bereich (A1), der an dem ersten Gehäuse (21) angeordnet ist, einen zweiten Bereich (A2), der an dem zweiten Gehäuse (22) angeordnet ist, und einen dritten Bereich (A3) umfasst, der den ersten Bereich (A1) und den zweiten Bereich (A2) miteinander verbindet und so platziert ist, dass er dem Scharnier (H) entspricht,
wobei die elektronische Vorrichtung (2) ferner eine erste Leiterplatte (451), die im ersten Gehäuse (21) angeordnet ist, eine zweite Leiterplatte (452), die im zweiten Gehäuse (22) angeordnet ist, und eine zweite flexible Leiterplatte (471) umfasst, die über das Scharnier (H) hinweg angeordnet ist und die erste Leiterplatte (451) und die zweite Leiterplatte (452) elektrisch miteinander verbindet,
wobei sich die Verlängerung (2402) des Anzeigemoduls (24) vom zweiten Bereich (A2) erstreckt, und
wobei die Anzeige (240) über die Verlängerung (2402) elektrisch mit der zweiten Leiterplatte (452) verbunden ist.

## Revendications

1. Dispositif électronique (2) comprenant :
un boîtier (20) comprenant un support (421) et une zone de surface latérale (422) reliée au support (421) ou s'étendant à partir de celui-ci, la zone de surface latérale (422) étant configurée pour fournir au moins une partie d'une surface latérale du dispositif électronique (2) ;
un module d'affichage (24) disposé sur le boîtier (20), dans lequel le module d'affichage (24) comprend
un affichage (240) comprenant une surface arrière supportée par le support (421), et
une extension (2402) comprenant une zone partielle (A4) disposée entre le support (421) et l'affichage (240) et une zone pliée (B) pliée et s'étendant de l'affichage (240) à la zone partielle (A4) ;
une pièce de support (27) évidée dans un évidement (R) prévu dans le support (421) ; et
un cadre (222) couplé au boîtier (20), dans lequel le cadre (222) comprend
une première partie (61) qui couvre une zone frontalière (A22) de l'affichage (240) et qui est exposée à l'extérieur, et
une deuxième partie (62) s'étendant depuis la première partie (61) jusqu'à un espace entre la zone pliée (B) de l'extension (2402) et la zone de surface latérale (422) du boîtier (20), **caractérisé en ce que** la deuxième partie (62) configurée pour être insérée dans un espace entre la pièce de support (27) et la zone de surface latérale (422) dans l'évidement (R).

2. Dispositif électronique de la revendication 1, dans lequel l'évidement (R) comprend une première surface (S1) et une deuxième surface (S2) faisant face à la première surface (S1) et espacée de la première surface (S1) dans une première direction par une deuxième distance W2,
dans lequel la pièce de support (27) présente une troisième surface (S3) faisant face à la première surface (S1),
dans lequel la troisième surface (S3) est espacée de la première surface (S1) dans la première direction d'une première distance (W1) inférieure à la deuxième distance (W2),
dans lequel un premier espace entre la première surface (S1) et la troisième surface (S3) ne chevauche pas un deuxième espace entre la première surface (S1) et la deuxième surface (S2) dans une vue du dessus d'une zone d'affichage (A21) de l'affichage (240), et
dans lequel la deuxième partie (62) est insérée dans le premier espace et le deuxième espace.

3. Dispositif électronique de la revendication 1 ou 2, dans lequel le boîtier (20) comprend une saillie (90) s'étendant de la zone de surface latérale (422) vers la pièce de support (27) dans une vue du dessus d'une zone d'affichage (A21) de l'affichage (240), et
dans lequel la saillie (90) est disposée dans l'évidement (R) et supporte la pièce de support (27).

4. Dispositif électronique de la revendication 3, dans lequel la deuxième partie (62) du cadre (222) comprend une encoche correspondant à la saillie (90).

5. Dispositif électronique de l'une quelconque des revendications 1 à 4, dans lequel la partie pliée (B) de l'extension (2402) est disposée entre la première partie (61) du cadre (222) et la pièce de support (27).

6. Dispositif électronique de l'une quelconque des revendications 1 à 5, dans lequel la zone pliée (B) de l'extension (2402) chevauche la pièce de support (27) dans une vue du dessus d'une zone d'affichage (A21) de l'affichage (240), et
dans lequel la pièce de support (27) est espacée du module d'affichage (24).

7. Dispositif électronique de l'une quelconque des revendications 1 à 6, comprenant en outre un premier élément d'encollage (261) disposé entre la pièce de support (27) et le boîtier (20).

8. Dispositif électronique de l'une quelconque des revendications 1 à 7, dans lequel la deuxième partie (62) du cadre (222) est reliée à la pièce de support (27).

9. Dispositif électronique de l'une quelconque des revendications 1 à 8, dans lequel la deuxième partie (62) est couplée au boîtier (20) par l'intermédiaire d'un deuxième élément d'encollage (262) disposé dans l'évidement (R).

10. Dispositif électronique de l'une des revendications 1 à 9, dans lequel le module d'affichage (24) comprend en outre une première carte de circuit imprimé flexible (2403) connectée électriquement à l'extension (2402),
dans lequel une zone partielle (A5) de la première carte de circuit imprimé flexible (2403) est disposée entre le support (421) et l'affichage (240) et couplée au support (421) par l'intermédiaire d'un troisième élément d'encollage (263), et
dans lequel le troisième élément d'encollage (263) ne chevauche pas la pièce de support (27) dans une vue du dessus d'une zone d'affichage (A21) de l'affichage (240).

11. Dispositif électronique de l'une quelconque des revendications 1 à 10, comprenant en outre un circuit de commande d'affichage (2401) disposé dans la zone partielle (A4) de l'extension (2402) disposée entre le support (421) et l'affichage (240).

12. Dispositif électronique de l'une quelconque des revendications 1 à 11, dans lequel au moins une partie conductrice comprise dans la zone de surface latérale (422) est connectée électriquement à un circuit de communication sans fil, et
dans lequel le cadre (222) comprend un matériau non conducteur.

13. Dispositif électronique de l'une quelconque des revendications 1 à 12, dans lequel une combinaison de la première partie (61) et de la zone de surface latérale (422) fournit un encadrement (B2) qui entoure au moins partiellement une zone d'affichage (A21) de l'affichage (240) dans une vue du dessus de l'affichage (240).

14. Dispositif électronique de l'une des revendications 1 à 13, dans lequel le boîtier (20) est un boîtier pliable configuré pour plier le module d'affichage (24).

15. Dispositif électronique de l'une quelconque des revendications 1 à 14, dans lequel le boîtier (20) comprend un premier boîtier (21), un deuxième boîtier (22), et une charnière (H) interconnectant le premier boîtier (21) et le deuxième boîtier (22),
dans lequel l'affichage (240) comprend une première zone (A1) disposée sur le premier boîtier (21), une deuxième zone (A2) disposée sur le deuxième boîtier (22), et une troisième zone (A3) interconnectant la première zone (A1) et la deuxième zone (A2) et située de manière à correspondre à la charnière (H),
dans lequel le dispositif électronique (2) comprend en outre une première carte de circuit imprimé (451) disposée dans le premier boîtier (21), une deuxième carte de circuit imprimé (452) disposée dans le deuxième boîtier (22), et une deuxième carte de circuit imprimé flexible (471) disposée en travers de la charnière (H) et interconnectant électriquement la première carte de circuit imprimé (451) et la deuxième carte de circuit imprimé (452),
dans lequel l'extension (2402) du module d'affichage (24) s'étend à partir de la deuxième zone (A2), et
dans lequel l'affichage (240) est connecté électriquement à la deuxième carte de circuit imprimé (452) par l'intermédiaire de l'extension (2402).
